(19)

Europäisches
Patentamt
European
Patent Office
Office européen
des brevets

(11) **EP 2 211 373 A1**

(12) **EUROPEAN PATENT APPLICATION**
published in accordance with Art. 153(4) EPC

(43) Date of publication:
**28.07.2010 Bulletin 2010/30**

(51) Int Cl.:
***H01L 21/3065*** (2006.01)   ***H01L 21/306*** (2006.01)
***H01L 33/00*** (2010.01)

(21) Application number: **08843452.7**

(22) Date of filing: **31.10.2008**

(86) International application number:
**PCT/JP2008/069920**

(87) International publication number:
**WO 2009/057764 (07.05.2009 Gazette 2009/19)**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **31.10.2007   JP 2007283560
31.10.2007   JP 2007283561
31.10.2007   JP 2007283562**

(71) Applicant: **Mitsubishi Chemical Corporation
Minato-ku
Tokyo 108-0014 (JP)**

(72) Inventors:
• **HORIE, Hideyoshi
Ushiku-shi
Ibaraki 300-1295 (JP)**
• **FUKADA, Takashi
Ushiku-shi
Ibaraki 300-1295 (JP)**

(74) Representative: **Luderschmidt, Schüler & Partner
Patentanwälte
John-F.-Kennedy-Strasse 4
65189 Wiesbaden (DE)**

(54) **ETCHING METHOD AND METHOD FOR MANUFACTURING OPTICAL/ELECTRONIC DEVICE USING THE SAME**

(57)     Disclosed is a semiconductor etching method whereby a semiconductor layer made of, for example, a Group III-V nitride semiconductor resistant to etching can be etched by a relatively easier process. This etching method comprises forming a metal-fluoride layer 3 at least as a part of an etching mask on the surface of a base structure (1,2); treating the metal-fluoride layer with a liquid; and etching the base structure using the metal-fluoride layer as a mask.

Fig. 5A

4 Resist mask layer

3 Etching mask layer

2 Semiconductor layer

1 Substrate

**Description**

Field of the Invention

The present invention relates to an etching method and a method for manufacturing photo/electronic device using the same. In particular, it relates to an etching method most suitably employed for etching of compound semiconductors, such as $In_xAl_yGa_{(1-x-y)}N$ Group III-V compound semiconductor (wherein $0\leq x\leq 1$, $0\leq y\leq 1$, $0\leq x+y\leq 1$), and a method by the etching method for manufacturing light emitting devices, such as light-emitting diodes (LED), super luminescent diodes, semiconductor lasers; light receiving devices, such as photodiodes and solar cells; and electronic devices, such as diodes and transistors.

Background Art

Electron devices and light-emitting devices having a Group III-V compound semiconductor are well-known. In particular, there have been practically used as a light-emitting device an AlGaAs or AlGaInP material formed on a GaAs substrate for red luminescence and a GaAsP material formed on a GaP substrate for orange or yellow luminescence. An infrared light-emitting device using an InGaAsP material on a InP substrate is also known.

As the types of these devices, a light-emitting diode utilizing spontaneous emissive light (light-emitting diode: LED), a laser diode having an optical feedback function for deriving an induced emissive light (laser diode: LD) and a semiconductor laser are known. These devices have been used as, for example, a display device, a communication device, a light-source device for high-density optical recording, a device for high-precision optical processing and a medical device.

Since 1990s, as results of attempts for research and development of an $In_xM_yGa_{(1-x-y)}N$ Group III-V compound semiconductor ($0\leq x\leq 1$, $0\leq y\leq 1$, $0\leq x+y\leq 1$) containing nitrogen as a Group V element, the emission efficiency of the devices using the same has been significantly improved, and blue and green LEDs with high efficiency have been realized. Subsequent research and development have led to LEDs with high efficiency even in the ultraviolet region and recently blue LEDs have been marketed.

By integrating a phosphor with an ultraviolet or blue LED as an excitation light source, a white LED can be obtained. Since a white LED may be utilized as a next-generation lighting device, improvement in output and efficiency in ultraviolet, near ultraviolet or blue LEDs to be an excitation light source has considerably higher industrial significance. At present, intense attempts are made for improving efficiency and output in a blue or ultraviolet in the light of applications in LED lighting.

For improving an output in an element, that is, improvement of the total radiation flux, increase of an element size and ensuring resistance to a large input power are essential. In addition, a common LED is a point light source. If adequately enlarged, the element exhibits light-emitting properties as a plane light source, which becomes particularly suitable for illumination applications.

However, an element having geometrical similarity with simply enlarged area of a common small LED does not exhibit uniform emission intensity over the whole element in general. There has been thus proposed integration of LEDs on a single substrate. For example, Japanese Laid-open Patent Publication No. 1999-150303 (Patent Reference 1) has disclosed an integrated light-emitting unit in which individual LEDs are series-connected as a light-emitting unit suitable as a surface light source. Japanese Laid-open Patent Publication No. 2002-26384 (Patent Reference 2) has disclosed a process for LED integration for the purpose of providing an integrated nitride semiconductor light-emitting element with a large area and a higher light-emission efficiency. For integration, it is necessary to electrically separate a pair of pn junction as a single light-emitting unit from other light-emitting units, and, therefore, technique of forming an effective "trench" in a nitride semiconductor layer is quite essential.

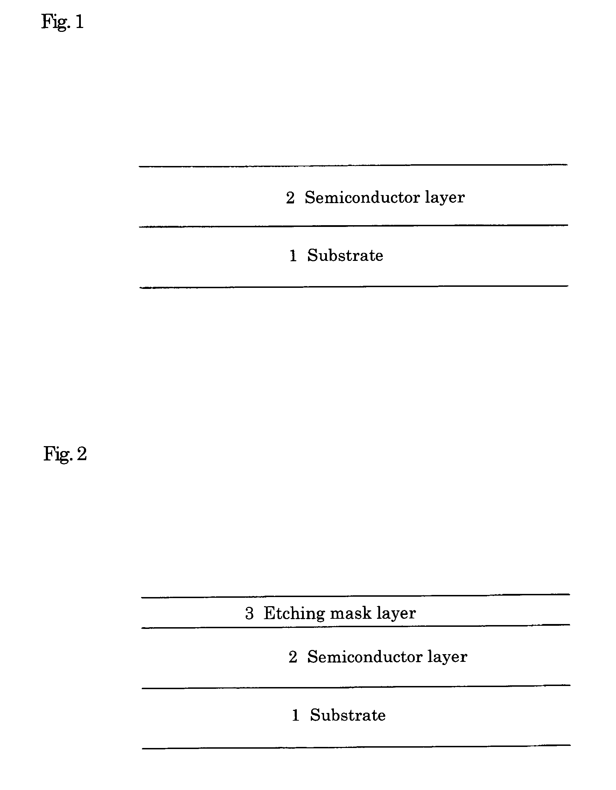

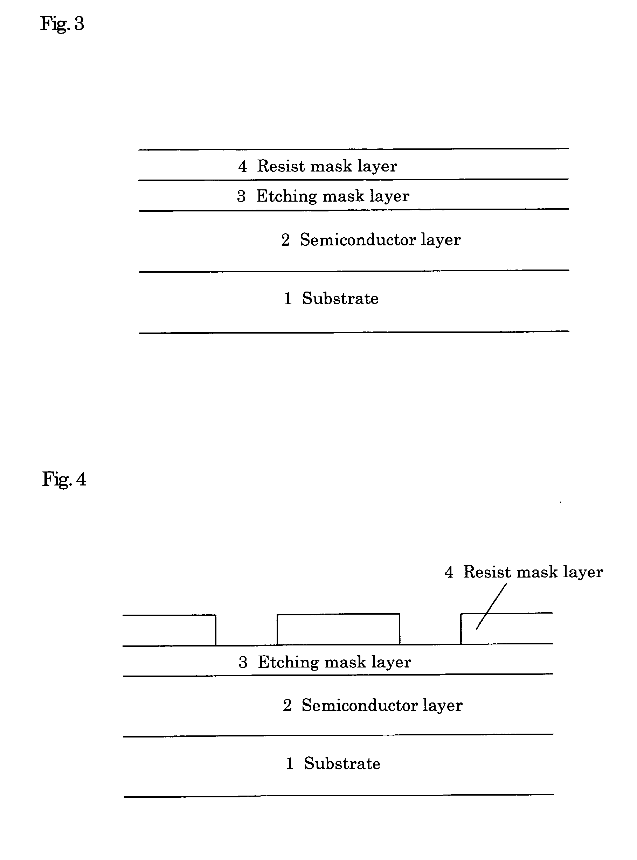

Japanese Laid-open Patent Publication No. 1999-150303 (Patent Reference 1) has disclosed that in order to separate a pair of pn junction, i.e. a single light-emitting unit, between units, a GaN layer is etched using an Ni mask until an insulative substrate is exposed (see, paragraph 0027 in Patent Reference 1). Furthermore, Japanese Laid-open Patent Publication No. 2002-26384 (Patent Reference 2) has disclosed that for separating a pair of pn junction as a single light-emitting unit from other light-emitting units, an inter-unit separation trench is formed by etching a GaN material using $SiO_2$ as a mask by RIE (reactive ion etching) until the etching reaches a sapphire substrate (see, FIG. 2, FIG. 3 and paragraph 0038 in Patent Reference 2).

However, a metal mask such as Ni used in Patent Reference 1, an oxide mask such as $SiO_2$ used in Patent Reference 2 and a known nitride mask such as SiN is insufficient in etching resistance and therefore insufficient in selection ratio as an etching mask for a GaN material. As a result, there has been difficulty in, for example, controlling an etching shape. As a practical problem, etching a thick GaN epitaxial layer having a thickness of several $\mu$m using an oxide mask such as $SiO_2$ requires an $SiO_2$ mask having an extremely large thickness, leading to poor productivity.

By the way, there has been proposed a fluoride mask in addition to the above metal, oxide and nitride masks.

For example, Journal of Vacuum Science and Technology B, Vol. 8, p.28, 1990 (Non-patent Reference 1) has described that an $SrF_2$ mask and an $AlF_3$ mask are formed by a lift-off method using a PMMA resist as masks for forming a separation trench in a GaN material, for etching an AlGaAs material and for conducting regrowth and further that an AlSrF mask is formed by a MBE method at room temperature. However, based on our investigation, a fluoride mask deposited at room temperature has insufficient properties. While it can work as an etching mask for a relatively easy-etching material such as an AlGaAs material, it is insufficiently resistant as an etching mask for a quite etching-resistant material such as a GaN material. A $SrF_2$ single-mask formed at room temperature has a problem of irregularity in its sidewall as described later.

Likewise, Japanese Laid-open Patent Publication No. 1994-310471 (Patent Reference 3) has disclosed that $SrF_2$ and $AlF_3$ formed by a lift-off method can be used for fine etching of a GaAs, InGaAs or InGaAsP material. Although this reference does not describe the conditions for depositing an etching mask, the mask is assumed to be formed at a mask deposition temperature from room temperature to at most about 100 °C, since the mask is patterned by a lift-off method using a resist susceptible to electron-beam exposure. As described above, a mask formed at about room temperature is insufficiently resistant as an etching mask for a GaN material. In addition, it has problems of occurrence of unintended side-etching and reduction of accuracy in transferring a shape of phtomask or photoresist used in patterning the $SrF_2$ to the shape of the $SrF_2$ itself.

Furthermore, Japanese Laid-open Patent Publication No. 1993-36648 (Patent Reference 4) has disclosed an approach that a GaAs material is etched using a metal or $SrF_2$ mask patterned by a lift-off method. Again, although this reference does not describe the conditions for depositing the $SrF_2$ mask, the mask is assumed to be formed at a mask deposition temperature from room temperature to at most about 100 °C since the mask is patterned by a lift-off method.

Patent Reference 1: Japanese Laid-open Patent Publication No. 1999-150303;
Patent Reference 2: Japanese Laid-open Patent Publication No. 2002-26384;
Patent Reference 3: Japanese Laid-open Patent Publication No. 1994-310471;
Patent Reference 4: Japanese Laid-open Patent Publication No. 1993-36648; and
Non-patent Reference 1: Journal of Vacuum Science and Technology B, Vol. 8, p.28, 1990.

<u>Disclosure of the Invention</u>

Subject to be solved by the Invention

In view of the problems in the prior art, an objective of the present invention is to provide an etching method capable of easily and accurately etching an etching-resistant semiconductor layer such as a Group III-V nitride semiconductor by a relatively simpler process.

Another objective of the present invention is to provide a method for manufacturing photo/electronic devices such as semiconductor devices, specifically semiconductor light emitting devices including the above etching method as one of the steps of manufacturing process.

Means to solve the Subject

The present invention relates to the following items.

1. An etching method, comprising the steps of:

forming a solid layer made of a metal fluoride at least as a part of an etching mask on the surface of a base structure;
treating the solid layer with a liquid; and
etching the base structure using the liquid-treated solid layer as a mask.

2. The etching method according to the above item 1, wherein the liquid is a resist composition.

3. The etching method according to the above item 2, wherein the step of treating with a resist composition comprises, as obligatory substeps,
substep (1): applying a resist composition to the solid layer; and substep (6): removing the resist composition.

4. The etching method according to the above item 3, wherein the step of treating with a resist composition further comprises at least one step selected from the substep group consisting of:

substep (2): first heating,
substep (3): first exposure,
substep (4): second heating and
substep (5): second exposure; and

wherein these substeps, together with the substeps (1) and (6), are performed in ascending order.

5. The etching method according to the above item 1, wherein the liquid is a chemical agent.
6. The etching method according to the above item 5, wherein the chemical agent contains at least one selected from the group consisting of water, an organic solvent, an organic acid, an alkaline solution and a hydrophobizing agent.
7. The etching method according to the above item 1, wherein the liquid is a polymer solution.
8. The etching method according to the above item 7, wherein the step of treating with a polymer solution comprises:

substep: applying a polymer solution to the solid layer, and
substep: removing the polymer on the solid layer.

9. The etching method according to the above item 8, wherein the step of removing the polymer comprises washing with a solvent.
10. The etching method according to any of the above items 1 to 9, comprising, after the step of treating with a liquid, steps of:

forming a patterned resist mask on the solid layer; and
etching the solid layer using the resist mask as an etching mask.

11. The etching method according to the above item 10, wherein the resist mask is formed from a photoresist.
12. The etching method according to the above item 10 or 11, wherein the step of etching a solid layer is conducted by wet etching.
13. The etching method according to the above item 12, wherein an etchant used in the wet etching contains at least one selected from the group consisting of hydrochloric acid, hydrofluoric acid and concentrated sulfuric acid.
14. The etching method according to any one of the above items 1 to 13, wherein the solid layer is formed at a temperature of 150 °C to 480 °C.
15. The etching method according to any one of the above items 1 to 14, wherein the solid layer is selected from the group consisting of $SrF_2$, $AlF_3$, $MgF_2$, $BaF_2$, $CaF_2$ and combinations thereof.
16. The etching method according to any one of the above items 1 to 15, wherein the step of etching a base structure is conducted by dry etching.
17. The etching method according to the above item 16, wherein the dry etching is plasma-excited dry etching using a gas species containing at least chlorine atom.
18. The etching method according to any one of the above items 1 to 17, comprising step of removing the solid layer by an etchant containing an acid or alkali after the step of etching a base structure.
19. The etching method according to any one of the above items 1 to 18, wherein the etching mask formed on the base structure comprises a multilayer structure having the solid layer and a second mask layer made of a material other than the material for the solid layer.
20. The etching method according to any one of the above items 1 to 19, wherein the base structure comprises a Group III-V nitride layer.
21. The etching method according to the above item 10, wherein a side-etching width measured from the patterned resist mask edge, which generates during step of etching the solid layer, is 6 $\mu$m or less.
22. The etching method according to the above item 21, wherein a side-etching width measured from the patterned resist mask edge, which generates during etching the solid layer, is 2 $\mu$m or less.
23. An etching method, comprising the steps of:

forming a solid layer having an inter-particulate void at least as a part of an etching mask on the surface of a base structure;
treating the solid layer with a liquid; and
etching the base structure using the liquid-treated solid layer as a mask.

24. A process for manufacturing a photo/electronic device comprising the etching method according to any of the above items 1 to 23, as one step.

Effect of the Invention

According to the present invention, there is provided an etching method capable of etching easily an etching-resistant semiconductor layer such as a Group III-V nitride semiconductor by a relatively simpler process. Particularly, according to the present invention, even when an original shape formed in, for example, a photomask or metal mask is a complex and fine pattern, it can be more accurately and more precisely transferred as a planar shape of an object to be etched after etching than a conventional method. Specifically, for example, the dimension of the object to be etched after etching can be significantly precisely matched with the dimension of an original shape formed in a photomask, compared with a conventional method, or the shape can be precisely projected with a desired projection magnification. Generally speaking, "transfer precision" in the overall processing can be considerably improved. The invention is, therefore, very useful for a process for manufacturing a semiconductor device or a semiconductor luminescent device, particularly a process for manufacturing a photo/electronic device involving etching of a Group III-V nitride semiconductor.

BRIEF DESCRIPTION OF THE DRAWINGS

FIG. 1 is a process cross-sectional view illustrating an etching method according to one embodiment.
FIG. 2 is a process cross-sectional view illustrating an etching method according to one embodiment.
FIG. 3 is a process cross-sectional view illustrating an etching method according to one embodiment.
FIG. 4 is a process cross-sectional view illustrating an etching method according to one embodiment.
FIG. 5A is a process cross-sectional view illustrating an etching method according to one embodiment.
FIG. 5B illustrates side etching.
FIG. 6 is a process cross-sectional view illustrating an etching method according to one embodiment.
FIG. 7 is a process cross-sectional view illustrating an etching method according to one embodiment.
FIG. 8 is a process cross-sectional view illustrating an etching method according to one embodiment.
FIG. 9 is a process cross-sectional view illustrating one embodiment in which an etching method of the present invention is applied to a semiconductor layer on whose surface a metal layer is formed.
FIG. 10 is a process cross-sectional view illustrating one embodiment in which an etching method of the present invention is applied to a semiconductor layer on whose surface a metal layer is formed.
FIG. 11 is a process cross-sectional view illustrating one embodiment in which an etching method of the present invention is applied to a semiconductor layer on whose surface a metal layer is formed.
FIG. 12 is a process cross-sectional view illustrating one embodiment in which an etching method of the present invention is applied to a semiconductor layer on whose surface a metal layer is formed.
FIG. 13 is a process cross-sectional view illustrating one embodiment in which an etching method of the present invention is applied to a semiconductor layer on whose surface a metal layer is formed.
FIG. 14 is a process cross-sectional view illustrating one simplified embodiment of etching a semiconductor layer on whose surface a metal layer is formed.
FIG. 15 is a process cross-sectional view illustrating one simplified embodiment of etching a semiconductor layer on whose surface a metal layer is formed.
FIG. 16A is a process cross-sectional view illustrating one simplified embodiment of etching a semiconductor layer on whose surface a metal layer is formed.
FIG. 16B is a process cross-sectional view illustrating one simplified embodiment of etching a semiconductor layer on whose surface a metal layer is formed.
FIG. 17 is a process cross-sectional view illustrating one simplified embodiment of etching a semiconductor layer on whose surface a metal layer is formed.
FIG. 18 is a process cross-sectional view illustrating one simplified embodiment of etching a semiconductor layer on whose surface a metal layer is formed.
FIG. 19 is a microscopy image of Example A1 and its schematic cross-sectional view.
FIG. 19B is a microscopy image of Example B1 and its schematic cross-sectional view.
FIG. 19C is a microscopy image of Example C1 and its schematic cross-sectional view.
FIG. 20 is a microscopy image of Reference Example A1 (B1, C1) and its schematic cross-sectional view.
FIG. 21 is a cross-sectional SEM photographic image of Example A2.
FIG. 21B is a cross-sectional SEM photographic image of Example B2.
FIG. 22 is a cross-sectional SEM photographic image of Reference Example A1 (B1, C1).
FIG. 23 a SEM photographic image of an $SrF_2$ layer without being treated with a chemical agent.
FIG. 24 is a SEM photographic image of an $SrF_2$ layer treated with a chemical agent in Example B9.
FIG. 25 is a SEM photographic image of an $SrF_2$ layer treated with a chemical agent in Example B10.
FIG. 26 is a SEM photographic image of an $SrF_2$ layer surface.
FIG. 27 is a SEM photographic image of a $CaF_2$ layer surface.

Explanation for numerals

1: substrate
2: semiconductor layer
3: etching mask layer (solid layer)
4: resist mask layer
7: electrode
8: electrode
9: etching mask layer (solid layer)
10: opening
11: trench
21: second etching mask (for example, $SiN_x$)
22: metal fluoride mask
25: concave
26: trench.

BEST MODE FOR CURRYING OUT THE INVENTION

In the present application, the term, "stacked" or "overlap" may refer to, in addition to the state that materials are directly in contact with each other, the state that even when being not in contact with each other, one material spatially overlaps the other material when one is projected to the other, as long as it does not depart from the gist of the invention. The term, "over or on …(under …)" may also refer to, in addition to the state that materials are directly in contact with each other and one is placed on (under) the other, the state that even when being not in contact with each other, one is placed over (below) the other, as long as it does not depart from the gist of the invention. Furthermore, the term, "after … (before or prior to …)" may be applied to not only the case where one event occurs immediately after (before) another event, but also the case where a third event intervenes between one event and another subsequent (preceding) event. The term, "contact" may refer to, in addition to the case where "materials are directly in contact with each other", the case where "materials are indirectly in contact with each other via a third member without being not directly in contact with each other" or where "a part where materials are directly in contact with each other and a part where they are indirectly in contact with each other via a third member are mixed" as long as it fits the spirit of the present invention. In addition, the term "numeric 1 to numeric 2" is used to mean a value equal to or more than numeric 1 and equal to or less than numeric 2.

Furthermore, in the present invention, "epitaxial growth" includes, in addition to formation of an epitaxial layer in a so-called crystal growth apparatus, subsequent carrier activation and the like of the epitaxial layer by, for example, heating, charged-particle treatment, plasma processing or the like.

As mentioned above, an etching method of the present invention comprises the steps of:

(a) forming a solid layer made of a metal fluoride or a solid layer having an inter-particulate void (hereinafter, each of which or collectively both of which may be simply referred to as "solid layer") at least as a part of an etching mask on the surface of a base structure;
(b) treating the solid layer with a liquid; and
(e) etching the base structure using the liquid-treated solid layer as a mask.

In the above etching method of the present invention, the liquid is preferably selected from the group consisting of resist compositions, chemical agents and polymer solutions.

Viewing phenomenally, the liquid treatment has brought some modification in chemical and/or physical state of the solid layer (including possibility of surface coating or the like). Another possible cause may be that ingredients used in the liquid treatment (a resist composition, a chemical agent, a polymer solution or the like) may have remained through chemical and/or physical bonding. By properly utilizing such modification, the solid layer becomes considerably useful as an accurate etching mask.

More specifically, when the solid layer is patterned using a resist, side etching of the solid layer itself from the resist end is reduced, resulting in improvement in pattern accuracy. Furthermore, in a process where a patterned solid layer is formed on a base structure surface and then treated with a liquid (a resist composition, a chemical agent, a polymer solution or the like), the present invention can be effective when the process involves a step in which the problem of side etching is significant or in which dissolution of the solid layer cause any problem.

A preferred aspect of the present invention comprises the steps of:

(a) forming a solid layer at least as a part of an etching mask on the surface of a base structure;
(b) treating the solid layer with a liquid;
(c) forming a patterned resist mask (for etching the solid layer) on the solid layer;
(d) etching the solid layer using the resist mask as an etching mask; and
(e) etching the base structure using the solid layer as a mask (for etching the base structure etching).

Here, in step (b) of liquid treatment in one preferable embodiment, the liquid is a resist composition, but the resist composition in the step of liquid treatment is used for treating a solid layer and is different from a resist mask formed in step (c). The resist mask formed in step (c) is a resist mask for precisely patterning the solid layer, and is then used in patterning the solid layer in step (d), and the patterned solid layer is used as a mask in etching the base structure. Looking at the etched and patterned solid layer immediately after step (d), a resist was applied on the solid layer at least once and then removed, thereafter a resist layer was formed over the solid layer.

There will be described the present invention in terms of steps (a) to (e) in sequence with reference to FIGs. 1 to 7.

Base structure

In the present invention, the term "base structure" ( = object to be etched) means the object to be etched by the etching method of the present invention, but particularly, means the object to be etched using the solid layer as a mask. A substrate described later means a commonly-used "substrate" used for supporting a layer (for example, semiconductor layer) and crystal growth. As described later, the substrate may be a base structure to be etched ( = object to be etched). In the present invention, there may be many variations in a material, a shape, a laminate structure and the like for a base structure to be etched.

Examples of a material for a base structure include, but not limited to, semiconductors, metals, and inorganic materials such as oxides and nitrides. The present invention can be applied to any base structure which can be etched, particularly by dry etching, using a solid layer etching mask (hereinafter, means "patterned solid layer"). Among others, a solid layer etching mask made of a metal fluoride exhibit extremely higher etching resistance, and thus, even when being used for a base structure insusceptible to etching by dry etching, can ensure a large etching selectivity, so that the effects of the present invention can be maximized.

For example, examples of a semiconductor material include, but not limited to, semiconductors generally used for a semiconductor device including silicon, germanium, diamond, Group III-V compound semiconductors such as GaN and Group II-VI compound semiconductors. Furthermore, oxide, nitride or oxynitride materials such as sapphire, aluminum oxide, aluminum nitride, boron nitride, silicon nitride, silicon oxynitride can be suitably etched. Furthermore, for example, a metal can be etched.

There are no particular restrictions to the shape or the configuration of a base structure, and for example, when an object to be etched has a semiconductor layer, the base structure can be a semiconductor substrate itself or a combination of a substrate (for example, a semiconductor substrate or an oxide substrate such as sapphire), a semiconductor layer formed on the substrate and, if necessary, an insulating layer and/or a metal layer. Here, only the part of the semiconductor layer (if necessary, including another layer such as an insulating layer) can be etched or an underlying substrate can be also etched.

Furthermore, there are no restrictions to a method for forming a semiconductor layer, and the present invention can be applied to a semiconductor layer formed by any method. When the present invention is applied to production of a light-emitting element, preferably, it is a layer formed over a substrate by film crystal growth technique such as epitaxial growth. Here, the term, "thin film crystal growth" may refer to formation of a thin film layer, amorphous layer, microcrystal, polycrystal, single crystal or a stacked structure of these in a crystal growth apparatus such as so-called MOCVD (Metal Organic Chemical Vapor Deposition), MBE (Molecular Beam Epitaxy), plasma-assisted MBE, PLD (Pulsed Laser Deposition), PED (Pulsed Electron Deposition), PSD (Pulsed sputtering Deposition), VPE (Vapor Phase Epitaxy), LPE (Liquid Phase Epitaxy), including, for example, a subsequent carrier activating process of a thin film layer such as heating and plasma treatment.

A material for a semiconductor layer which is very useful and generally resistant to dry etching, that is, a semiconductor to which the etching method of the present invention is suitably applied, preferably contains an element selected from In, Ga, Al, B and a combination of two or more of these as a constituent element; further preferably, the semiconductor layer contains nitrogen as a Group V element; most preferably, the semiconductor layer contains only nitrogen as a Group V element. The semiconductor layer may be specifically made of a Group III-V nitride semiconductor (hereinafter, sometimes referred to as "GaN-based semiconductor" for simplicity) such as GaN, InN, AlN, BN, InGaN, AlGaN, InAlN, InAlGaN and InAlBGaN (hereinafter, sometimes referred to as "GaN semiconductor" for simplicity). These may, if necessary, contain an element such as Si and Mg as a dopant.

The present invention can be also suitably used in etching a semiconductor other than a Group III-V nitride semiconductor such as GaAs, GaP, InP and Si semiconductors.

The semiconductor layer may have a multilayer structure and when the present invention is used for preparing a Group III-V nitride semiconductor (GaN-based material) light-emitting element, the semiconductor layer desirably contains, for example, a buffer layer, a first conductivity type cladding layer, a first conductivity type contact layer, an active layer structure, a second conductivity type cladding layer and a second conductivity type contact layer, which are grown by thin-film crystal growth (typically, epitaxial growth). Examples of a preferable base structure to which the present invention can be applied may include, a GaN epitaxial layer on a sapphire substrate and a GaN epitaxial layer on a GaN substrate.

There has been described, as a typical example, the case where, as shown in FIG. 1, a base structure of the object to be etched has substrate 1 and semiconductor layer 2 formed on the substrate, and the part to be etched is only the semiconductor layer 2. However, the present invention can be also applied a case where the semiconductor layer 2 is absent and the substrate itself is a base structure to be dry etched or a case where both substrate 1 and semiconductor layer 2 are to be etched. The preferable base structure in this case may be a GaN epitaxial layer on a sapphire substrate or a GaN epitaxial layer on a GaN substrate as same as those described above.

There are no particular restrictions to a substrate on which a semiconductor layer is formed as long as it allows for forming a desired semiconductor layer; for example, semiconductor substrates and ceramic substrates, insulative substrates and conductive substrates, and transparent substrates and opaque substrates can be used. Preferably, it is appropriately chosen in the light of, for example, a desired semiconductor device and a manufacturing process for a semiconductor.

For example, when a GaN-based light-emitting element structure with which the light extraction from the substrate side is intended is prepared, it is desirably substantially optically transparent to an emission wavelength of an element. The term, "substantially transparent" as used herein, means no absorption to an emission wavelength or, if present, absorption by a substrate which reduces an optical output by less than 50 %. Furthermore, an electrically insulative substrate is preferable for manufacturing a GaN-based light-emitting element. It is because even if a solder material adheres to the periphery of the substrate assuming that so-called flip-chip mounting is conducted, it does not affect current injection into a semiconductor light-emitting device. Here, specific examples of the material is preferably selected from sapphire, SiC, GaN, $LiGaO_2$, ZnO, $ScAlMgO_4$, $NdGaO_3$ and MgO, particularly preferably sapphire, GaN and ZnO substrates for epitaxially growing an InAlGaN light-emitting material or an InAlBGaN material over the substrate. In particular, when a GaN substrate is used, its Si doping concentration is desirably a Si concentration of $1 \times 10^{18}$ cm$^{-3}$ or less in the case an undoped substrate is intentionally used, more desirably $8 \times 10^{17}$ cm$^{-3}$ or less in the light of electric resistance and crystallinity.

A substrate used in this invention is desirably, in addition to a just-substrate completely defined by a so-called plane index, a so-called off-substrate (miss oriented substrate) in the light of controlling crystallinity during epitaxial growth. An off-substrate is, when a semiconductor layer formed on it is an epitaxial layer, widely used as a substrate because it is effective for promoting favorable crystal growth in a step flow mode and thus effective for improving a morphology of a semiconductor layer. For example, when a c+ plane substrate of sapphire is used as a substrate for crystal growth of a GaN-based material, it is preferable to use a plane inclined to an m+ direction at an angle of about 0.2 °. An off-substrate having a small inclination of about 0.1 to 0.2 ° is generally used, but in a GaN-based material formed on sapphire, a relatively larger off-angle is possible for canceling an electric field due to piezoelectric effect to a quantum well layer as a light-emitting point within an active layer structure.

A substrate may be pretreated by chemical etching or heating for manufacturing a semiconductor layer utilizing crystal growth technique such as MOCVD and MBE. Alternatively, a surface of a substrate to which a semiconductor layer is to be grown may be deliberately processed to have irregularity to prevent penetrating dislocation generated in an interface between an epitaxial layer and the substrate from being introduced near an active layer of a light-emitting element in a light-emitting unit described later. In this case, an etching mask layer is formed on concave-convex surface, but the present invention allows for an excellent etching mask layer even in such a case.

A thickness of the substrate is selected in the light of a desired semiconductor device and a semiconductor process, and is generally preferably, for example, about 250 to 700 μm in an initial stage of device preparation for ensuring mechanical strength during the element manufacturing process. After growing a semiconductor layer by sputtering, vapor deposition or epitaxial growth, it is desirable that for facilitating separation into individual elements, the substrate is appropriately thinned by a polishing step in the course of the process.

Solid layer

In an etching method of the present invention, a solid layer made of a metal fluoride or a solid layer having an inter-particulate void is formed on the surface of a base structure at least as a part of an etching mask. Since a metal fluoride has good film quality and shows good performance in subsequent etching of the metal fluoride layer and etching of the base structure, it is used as a preferable material. Meanwhile, independently of the material viewpoint, a solid layer having an inter-particulate void can be regarded as a preferable structure from the viewpoint of a electron-microscopic structure of the solid layer.

First, there will be detailed formation of a solid layer made of a metal fluoride.

An first etching method according to the present invention comprises the steps of:

(a) forming a solid layer made of a metal fluoride at least as a part of an etching mask on the surface of a base structure;
(b) treating the solid layer with a liquid; and
(e) etching the base structure using the liquid-treated solid layer as a mask.

Deposition of a metal fluoride layer

FIG. 2 shows a state after forming an etching mask layer 3 on a semiconductor layer 2. The etching mask layer contains at least one metal-fluoride layer. In this example, the etching mask layer 3 consists of one layer of the metal-fluoride layer.

A material for the metal-fluoride layer may be a fluoride of a bivalent or trivalent metal, particularly a fluoride of a metal element selected from Groups 2 (2A), 3 (3A), 12 (2B) and 13 (3B) in the long-form periodic table. Specific examples include $SrF_2$, $CaF_2$, $MgF_2$, $BaF_2$ and $AlF_3$, preferably $SrF_2$, $CaF_2$ and $MgF_2$ in the light of balance between dry etching resistance and wet etching properties, and among these, $CaF_2$ and $SrF_2$ are preferable, $SrF_2$ is the most preferable.

As described above, it has been proposed to use a metal-fluoride such as $SrF_2$ as an etching mask, but the mask pattern is formed by a lift-off method using a photoresist. However, in the process for forming a mask pattern by a lift-off method, the metal-fluoride mask is not formed at high temperature because a photoresist cannot to be exposed to high temperature. Generally, a mask deposited at about ambient temperature has insufficient film properties.. In the preferred embodiment of the present invention, the patterning of the metal-fluoride is carried out by etching, in particular wet etching. This extends the range of temperature of the film formation wider and enables the film formation at higher temperature. Therefore, the formation of patterning mask made of a metal-fluoride having improved film quality is realized.

A metal fluoride layer is deposited preferably at a temperature of 150 °C or higher. Deposition at 150 °C or higher can form a dense film exhibiting notably good adherence to the underlying layer. At the same time, the planar shape of the resist pattern can be accurately transferred to the planar shape of the metal fluoride layer by etching of the metal fluoride layer. For example, when an opening with linear shape is formed or a stripe pattern is formed, a metal fluoride layer is excellent in linearity of its side wall and transfer accuracy of a planar shape from a resist pattern. In addition, depending on the type of a liquid used in liquid treatment described later (for example, treatment with a resist composition, treatment with a chemical agent and treatment with a polymer solution), even a metal fluoride layer deposited at a temperature of about room temperature to less than 150 °C can be used because it can exhibit excellent transfer accuracy.

Generally, a deposition temperature is preferably a relatively higher temperature. That is, the temperature is more preferably 250 °C or higher, further preferably 300 °C or higher, most preferably 350 °C or higher. In particular, a metal fluoride layer deposited at 350 °C or higher is excellent in adherence to any type of underlying layer and is a denser film than that deposited at a relatively lower temperature, and thus exhibits higher dry etching resistance. In terms of a patterning shape of a metal fluoride itself when the metal fluoride is etched using a different material such as a resist mask and a metal mask, transfer accuracy (linearity of a side wall part when a pattern is linear) is very excellent and controllability of a width of an opening is ensured. Such a metal fluoride layer is most preferable as an etching mask for a base structure. In the present invention, controllability of a width of an opening and shape controllability are significantly improved in combination with the effects of liquid treatment described later. In the following description, deposition at 150 °C or higher is sometimes abbreviated as "high-temperature deposition".

As described above, high-temperature deposition is preferable for making an etching mask which exhibits good adherence to an underlying layer, is a dense film and exhibits improved dry etching resistance while exhibiting very excellent transfer accuracy in terms of a patterning shape. However, on the other hand, at an excessively higher deposition temperature, the mask becomes excessively resistant to an etchant in wet etching described later, making patterning using a photoresist or removal of the mask difficult. In particular, as described later, for a mask such as $SrF_2$ exposed to plasma such as chlorine during dry etching of a semiconductor layer, the etching rate during removal of the mask layer in the later step tends to be reduced in comparison with that before exposure to plasma such as chlorine. Thus, deposition of a metal fluoride at an excessively high temperature is undesirable in the light of patterning and final removal of the layer.

In a metal fluoride before exposure to plasma during dry etching of a semiconductor layer, a layer deposited at a lower temperature exhibits a higher etching rate to an etchant such as hydrochloric acid, resulting in faster etching while a layer deposited at a higher temperature exhibits a lower etching rate, resulting in slower etching. At a deposition temperature of 300 °C or higher, an etching rate noticeably decreases in comparison with a film deposited at about 250 °C, and at about 350 to 450 °C, an etching rate is within a very advantageous range. However, at a deposition temperature of higher than 480 °C, an absolute value of an etching rate is excessively reduced, so that patterning a metal fluoride layer may take a too long time and patterning may become difficult under the conditions where a resist mask layer is not detached. Furthermore, in a metal fluoride layer after exposure to plasma during dry etching of the semiconductor layer, a wet etching rate to, for example, hydrochloric acid during removal tends to be reduced, and thus, deposition at an excessively higher temperature makes it difficult to remove a metal fluoride layer which becomes no longer necessary after etching of the semiconductor layer.

Furthermore, deposition of a metal-fluoride at an excessively elevated temperature gives excessive heat history to a substrate, a semiconductor layer or a metal layer formed on the semiconductor layer as described later, and thus a mask formation process may adversely affect a device during manufacturing process of a semiconductor light-emitting element and the like.

From such a viewpoint, a deposition temperature of a metal-fluoride layer is preferably 480 °C or lower, further preferably 470 °C or lower, particularly preferably 460 °C or lower.

For the conditions of etching a semiconductor layer, an etching selectivity between a base structure such as a semiconductor layer and a metal fluoride layer is 40 or more, preferably 200 or more, further preferably 400 or more, which is achievable in a Group III-V nitride semiconductor.

The metal-fluoride layer can be formed by a common film deposition method such as sputtering, electron beam vapor evaporation and vacuum evaporation. However, sputtering or electron beam vapor evaporation may give an etching mask with a low selection ratio. This would be because electrons or ions directly collide a fluoride to possibly dissociate the fluoride into a metal and fluorine depending on the conditions. Therefore, in these film deposition methods, the deposition conditions must be properly selected, leading to restrictions to the manufacturing conditions. On the other hand, vacuum evaporation using, for example, resistance heating does not have such a problem and, therefore, is the most desirable. Even a vapor evaporation method using electron beam is desirable like the resistance heating method if indirect heating is employed, for example, by heating a crucible containing a material by electron beam rather than direct irradiation of a fluoride material with electron beam. By these vapor evaporation methods, a metal-fluoride layer exhibiting good dry etching resistance can be easily deposited.

A deposition rate of a metal fluoride layer such as $SrF_2$ is preferably in the range of about 0.03 nm/sec to 3 nm/sec, further preferably about 0.07 nm/sec to 2.0 nm/sec, most preferably about 0.10 nm/sec to 1.0 nm/sec. A metal fluoride layer deposited under this range is more desirable because it exhibits good adherence to an underlying layer and resistance to plasma can be ensured.

Features of a solid layer from the viewpoint of a structure

There has been detailed an etching method of the present invention, where the solid layer formed at least as a part of an etching mask was discussed from the viewpoint of materials such as a metal fluoride. Meanwhile, we have found that independently of such a viewpoint of materials, the solid layer can be discussed from a viewpoint of structure in electron microscopy level.

That is, a second etching method of the present invention comprises the steps of:

(a) forming a solid layer having an inter-particulate void at least as a part of an etching mask on the surface of a base structure;
(b) treating the solid layer with a liquid; and
(e) etching the base structure using the liquid-treated solid layer as a mask.

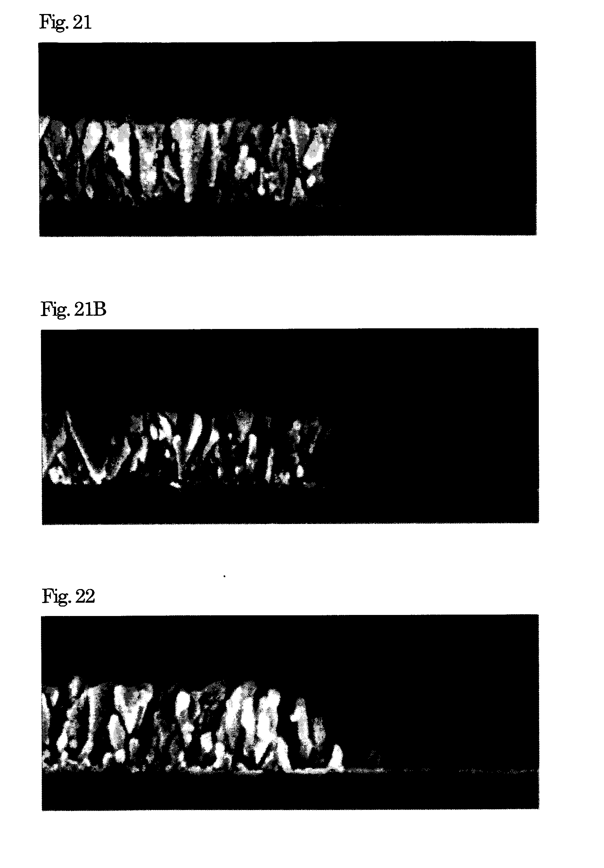

Here, an inter-particulate void means a relatively macro void spontaneously formed during one film-deposition run while a material and forming conditions are appropriately selected. A relatively macro void is present between fine particles constituting the solid layer as seen in FIGs. 21, 22, 26 and 27, and more specifically, is a void having, for example, a size of about several nm to several ten nm (generally, 1 to 50 nm). A relatively macro void does not mean such a void that is formed by artificially forming an opening on and patterning an SiNx film by a common photolithographic process. Furthermore, it does not mean a non-space connecting region between crystals constituting a "polycrystal", like a mere crystal grain boundary observed in a so-called polycrystal.

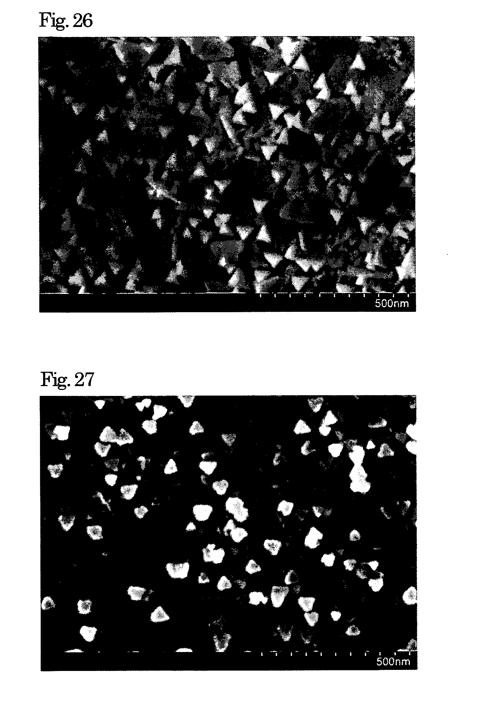

Such an inter-particulate void can be observed in an image enlarged by, for example, SEM as seen in FIGs. 21 and 22 (cross-sectional image) or FIGs. 26 and 27(surface image).

The amount of the inter-particulate void present in the upper surface of the solid layer can be estimated from a surface porosity measured as followed.

Here, a surface porosity of a solid layer used in the second etching method of the present invention is generally 0.5 % or more and generally 15 % or less, preferably 8 % or less. A too high surface porosity may result in an inadequately dense solid layer, leading to deterioration in dry etching resistance in some cases. A too low surface porosity may lead to insufficient effects of liquid treatment in the present invention. For example, a surface porosity is about 2.7 % and about 0.9 % for an SrF$_2$ layer in FIG. 26 and a CaF$_2$ layer in FIG. 27, respectively.

Measuring method of a surface porosity

(i) A photographic image of a film of a solid layer is taken using an electron microscope such as SEM, and the sum of the void area in the image taken is determined and calculated. Here, in the photographic image taken for the surface of the solid layer, fine particles and inter-particulate voids can be distinguished as a contrast in the image. Based on the results, the sum of the void area is determined.
(ii) The area of the photographed region (the overall solid layer including the voids) is measured and calculated.
(iii) A surface porosity is calculated from the following equation.

$$\text{Surface porosity} = \text{the sum of the void area} / \text{the area of the photographed region}$$

It is generally known that when, for example, SEM is used for measuring a length, an error of about 10 % occurs. Furthermore, there occurs an error when a SEM image is defocused due to surface irregularity or an error of positional shift of the void edge due to contrast processing of the image. These may possibly cause an error of a measured surface porosity within about $\pm$ 50%.

There are no particular restrictions to a material constituting a solid layer having an inter-particulate void, but as described above, it is preferably a metal fluoride in the light of ensuring good film properties and satisfactory etching of the solid layer and of the base structure.

The solid layer having an inter-particulate void must be a dense film for ensuring high dry etching resistance, but for example, even in a solid layer such as SrF$_2$ exhibiting high etching resistance, there is a void between fine particles grown as illustrated in FIG. 21, 22, 26 or 27. Although the mechanism of reduction in side etch is unclear and a matter for speculation, it can be speculated that improvement in resistance to an etchant, improvement in the effect of etchant repelling (hydrophobicity), improvement in affinity and/or permeability to a photoresist (for etching a solid layer) and the effect of preventing fine particle detachment occur alone or in combination, and particularly, the effects can be significant when there is a void between fine particles and the void becomes in contact with a liquid, causing chemical and/or physical modification. In the present invention, the liquid preferably contains one or more of a resist composition, a chemical agent and a polymer solution.

There will be detailed an embodiment which is common to formation of a solid layer made of a metal fluoride (the first etching method of the present invention) and forming of a solid layer having an inter-particulate void (the second etching method of the present invention). The term, "solid layer" as used hereinafter means, unless otherwise indicated, both a solid layer made of a metal fluoride and a solid layer having an inter-particulate void.

In the present invention, an etching mask layer can be a monolayer film of a solid layer or a multilayer film of such layers, or alternatively, a multilayer structure in combination with a second mask layer made of a material other than that constituting the solid layer. In the present invention, it is just required that the solid layer is exposed on a surface to be able to protect the underlying structure during etching of the semiconductor layer. Therefore, another layer may be formed in the semiconductor layer side, for the purpose of protection of a semiconductor or a component formed on a semiconductor or for other purpose. In one embodiment of the present invention, for example, as described later, it is also preferable to form a multilayer film in which a film such as SiN$_x$ and SiO$_x$ is formed as a second mask layer under the solid layer for preventing the metal layer from being removed when the solid layer is finally removed. Furthermore, in addition to the second mask layer formed under the solid layer, a third mask layer may be formed over the solid layer. These can be appropriately selected, depending on a purpose.

Treatment of a solid layer with a liquid

Next, the above solid layer deposited is treated with a liquid. The liquid preferably contains, as described above, at least one selected from the group consisting of resist compositions, chemical agents and polymer solutions. Here, the three processes of (A) treatment with a resist composition, (B) treatment with a chemical agent and (C) treatment with a polymer solution will be separately described.

(A) Treatment with a resist composition

Treatment of a solid layer with a resist composition

As a first aspect, the solid layer deposited is treated with a resist composition. This step of treatment with a resist composition is effective for preventing side etching in patterning of the solid layer using another mask material described later, and is thus essential step for improving transfer accuracy. "The step of treatment with a resist composition" involves contacting the resist composition with the solid layer, and generally has substep (1): applying the resist composition to the solid layer, and substep (6): removing the resist composition.

The term, "resist composition" as used herein, means any type including that applicable to the solid layer in substep (1) and that just before being removed in substep (6). When the term is used for describing a particular type, it will be explicitly specified or it is obvious from the context in which the term is used.

More specifically, the step of treatment with a resist composition includes substeps (1) and (6) as essential steps and substeps (2) to (5) as optional steps.

Substep (1): applying a resist composition to the solid layer;
Substep (2): first heating;
Substep (3): first exposure;
Substep (4): second heating;
Substep (5): second exposure; and
Substep (6): removing the resist composition.

In common positive resist processes and some negative resist processes (patterning including application, exposure and development), the above substeps (1), (2), (3), (4) and (6) are generally essential while in the other negative resist processes, all of (1) to (6) are essential. However, since the purpose of the present invention is not patterning, substeps (2) to (5) are optional and can be omitted or appropriately conducted. When being conducted, these substeps along with the essential substeps (1) and (6) are performed in ascending order.

When being applied in substep (1), the resist composition is a liquid containing a resist base resin, photosensitizing agent, an organic solvent and the like. When the resist composition in this state generally available from the market is distinctly mentioned, the term, "resist solution" may also be used in some cases.

The resist composition (resist solution) can be applied to the solid layer in substep (1) by any method; for example, spin coating, screen printing, dip coating, spray coating, curtain coating, slit coating, roll coating, dispenser application and the like. Here, vibration may be applied for ensuring adequate contact of the resist composition with the surface of the solid layer (including the surface of the inter-particulate void). There are no particular restrictions to the temperature for application as long as the resist composition in a state of solution can be applied and can be determined, taking a melting point and a boiling point of a solvent contained and the like into consideration, and may be generally about room temperature (about 10 °C to about 35 °C).

The substep (2) is the first heating step. When a relatively thinner film is formed using a common resist solution by, for example, spin coating, most of the solvent in the resist composition has been, after the application step, evaporated, leaving the resist composition as a solid film, which still contains the solvent and may be a soft and sticky film. Thus, for drying and hardening the film, a common resist process involves a heating step called as prebaking. The first heating step as the substep (2) in the present invention corresponds to a so-called prebaking step. Generally, prebaking is conducted at a temperature of 50 to 150 °C, but since the present invention does not aim at forming a precise pattern by this treatment with a resist composition, the prebaking can be conducted at a temperature higher than room temperature and equal to or lower than a temperature at which the resist composition can be removed in the substep (6) later. It is for example 40 °C to 200 °C, preferably about 40 °C to 160 °C, more preferably 50 to 150 °C.

A heating time in the first heating step can be appropriately selected; for example, 10 sec to 1 hour, preferably about 20 sec to 30 min.

The substep (3) is the first exposure step. The first exposure step corresponds to pattern exposure using a photomask or reduced projection in a common resist process. An exposure wavelength can be appropriately selected, depending on the type of a resist material; for example, ultraviolet, far-ultraviolet, excimer laser, X-ray and electron beam, and generally, i-line, g-line or excimer laser such as KrF, ArF and $F_2$ is used and a known method can be used for exposure. In the treatment with a resist composition of the present invention, this exposure step may or may not be conducted, and therefore, if conducted, can be conducted either in whole exposure or in pattern exposure using a photomask or reduced projection, and may or may not be conducted regardless of whether the resist is of positive or negative type.

The substep (4) is the second heating step. The step corresponds to post-exposure baking for positive type, image reversal baking (reversal bake) for negative type (image reversal type) and the like in a common resist process, and can be conducted at about 80 °C to about 150 °C. However, since the present invention does not aim at forming a precise pattern by this treatment with a resist composition, this step can be conducted at a temperature higher than room temperature and equal to or lower than a temperature at which the resist composition can be removed in the substep (6) later. It is for example 40 °C to 200 °C, preferably about 40 °C to 160 °C, more preferably 50 to 150 °C. However, when both first and second heating steps are conducted, in particular when the first and the second heating steps are conducted without the exposure step of the substep (3), it is also preferable that a temperature of the second heating step is higher than a temperature of the first heating step.

A heating time in the second heating step can be also appropriately selected; for example, 10 sec to 1 hour, preferably about 20 sec to 30 min.

The substep (5) is the second exposure step. This step corresponds to whole exposure (flood exposure) in the process using a negative (image reversal type) resist in a common resist process, and in the present invention, may or may not be conducted when a negative (image reversal type) resist is used. In a resist process using a positive type or cross-linked negative type, this step is generally unnecessary or meaningless, but may be conducted.

The substep (6) is the step of removing a resist composition, which is removed from at least a part of the solid layer or the whole solid layer. The resist composition can be removed under a method and conditions which do not interfere with the subsequent processes {(c) forming a resist mask (for solid layer etching) and (d) solid layer etching} and allows treatment with a resist composition to be effective.

Examples may include treatment with a developing solution, washing with an organic solvent, plasma ashing and a combination of these.

For removing the resist composition mainly by treatment with a developing solution, the first exposure step and, if necessary, the second exposure step must be properly combined. The developing solution may be generally an alkaline solution containing an alkylammonium hydroxide such as tetramethylammonium hydroxide or an organic solvent. For a positive resist, the resist composition in the exposed area (the whole surface in case of whole exposure) is dissolved and removed, while for a negative resist, the resist composition in the unexposed area in the first exposure step (the whole surface in case of no exposure) is dissolved and removed. Here, treatment with a developing solution means that a resist used is contacted with a liquid acting as a developing solution, but does not mean image formation. However, only the resist composition in a required area can be removed by the treatment in combination with exposure. After the developing step, washing with water can be, if necessary, conducted.

It is also possible that no area is removed by the treatment with a developing solution. In such a case, the resist composition is removed substantially by another method.

The organic solvent which can be used for removing the resist composition may be any solvent as long as it does not influence the base structure and can dissolve the remaining resist composition layer. Specific examples include lower alcohols such as methanol, ethanol and isopropyl alcohol (preferably having up to 4 carbon atoms); and ketones such as acetone and methyl ethyl ketone. Two or more organic solvents can be combined and in such a case, they can be mixed and/or sequentially used. After removing the residual resist composition with an organic solvent, it is also preferable to wash the solid layer with water. Then, after optional drying, the subsequent step of forming a resist mask (for etching a solid layer) follows. The drying may be conducted by spin drying, dry-air spraying or the like.

The resist composition can be removed by an alternative method such as oxygen plasma ashing.

Among the substeps (2) to (5), at least one of the substep (2): first heating and the substep (4): second heating, preferably both are conducted.

The resist material which can be used in the step of treatment with a resist composition as described above can be a known resist whose solubility in a developing solution is modified by light irradiation such as near-ultraviolet (g-line, i-line or the like; near UV), deep ultraviolet (deep UV), vacuum ultraviolet (vacuum UV) and extreme ultraviolet (extreme UV) or energy beam irradiation such as electron beam and heat, and may be of a positive or negative type.

For example, a typical resist material for i-line, g-line and the like contains, as main components, a base resin containing a novolac resin such as a cresol novolac resin as a main component, a quinonediazide derivative such as naphthoquinonediazidesulfonyl chloride as a photosensitizing agent and an organic solvent. Furthermore, also preferable is a resist material which is converted to a negative type by adding additives to these resist.

Furthermore, a chemical amplification resist for a short-wavelength light source containing a polymer and an acid generator which generates an acid by exposure can be used. Known examples of the polymer contained in this type of resist include, but not limited to, (co)polymers in which OH in polyhydroxystyrene is modified by a protective group such as t-butoxycarbonyl and (co)polymers of a polymethacrylate derivative.

Specific examples include commercially available products such as MCPR series from Shipley Far East Ltd., OFPR series and OAP series from Tokyo Ohka Kogyo Co., Ltd. and AZ series from AZ Electronic Materials K.K.

Examples of the solvent preferably contained in such a resist composition may include polyols such as ethylene glycol, propylene glycol, butanediol, glycerol and polyoxyethylene;

(poly)alkylene glycol monoalkyl ethers such as ethylene glycol monomethyl ether, ethylene glycol monoethyl ether, ethylene glycol mono-n-propyl ether, ethylene glycol mono-n-butyl ether, diethylene glycol monomethyl ether, diethylene glycol monoethyl ether, diethylene glycol mono-n-propyl ether, diethylene glycol mono-n-butyl ether, triethylene glycol monomethyl ether, triethylene glycol monoethyl ether, propylene glycol monomethyl ether, propylene glycol monoethyl ether, propylene glycol mono-n-propyl ether, propylene glycol mono-n-butyl ether, dipropylene glycol monomethyl ether, dipropylene glycol monoethyl ether, dipropylene glycol mono-n-propyl ether, dipropylene glycol mono-n-butyl ether, tripropylene glycol monomethyl ether and tripropylene glycol monoethyl ether;

ketones having preferably 20 or less, more preferably 10 or less carbon atoms such as acetone, methyl ethyl ketone, diethyl ketone, cyclohexanone, methyl isoamyl ketone and 2-heptanone;

esters including alkyl esters (having preferably 20 or less, further preferably 12 or less carbon atoms) such as ethyl acetate, n-propyl acetate, i-propyl acetate, n-butyl acetate, i-butyl acetate, n-pentyl formate, i-pentyl acetate, n-butyl propionate, ethyl butyrate, n-propyl butyrate, i-propyl butyrate and n-butyl butyrate; alkyl lactates such as methyl 2-hydroxypropionate, ethyl 2-hydroxypropionate and butyl 2-hydroxypropionate; substituted alkyl esters having alkoxy or oxyalkyl (having preferably 20 or less, further preferably 12 or less carbon atoms) such as ethyl 2-hydroxy-2-methylpropionate, methyl 3-methoxypropionate, ethyl 3-methoxypropionate, methyl 3-ethoxypropionate, ethyl 3-ethoxypropionate, ethyl ethoxyacetate, ethyl hydroxyacetate, methyl 2-hydroxy-3-methylbutanoate, 3-methyl-3-methoxybutyl acetate and 3-methyl-3-methoxybutyl propionate; other esters such as methyl pyruvate, ethyl pyruvate, n-propyl pyruvate, methyl acetoacetate, ethyl acetoacetate and ethyl 2-oxobutanoate; and (poly)alkylene glycol monoalkylether acetates such as ethylene glycol monomethyl ether acetate, ethylene glycol monoethyl ether acetate, diethylene glycol monomethyl ether acetate, diethylene glycol monoethyl ether acetate, propylene glycol monomethyl ether acetate and propylene glycol monoethyl ether acetate;

linear or branched-chain dialkyl ethers such as dimethyl ether and diethyl ether; and cyclic ethers such as tetrahydrofuran, tetrahydropyrane, oxetane and dioxane.

Particularly preferred are propylene glycol monomethyl acetate, ethylcellosolve acetate, ethyl lactate and propyl lactate.

Although the mechanism of reduction in side etch achievable by treatment with a resist composition which is characteristic in the present invention is unclear and a matter for speculation, it can be speculated that improvement in resistance to an etchant, improvement in the effect of etchant repelling (hydrophobicity), improvement in affinity and/or permeability to a photoresist (for etching a solid layer) and the effect of preventing fine particle detachment occur alone or in combination.

(B) Treatment with a chemical agent

Treatment of a solid layer with a chemical agent

A second aspect involves treatment of a solid layer deposited with a chemical agent. The term, "step of treatment with a chemical agent" as used herein, includes contacting a solid layer with a chemical agent, and then, if necessary, washing and drying the layer. The step of treatment with a chemical agent is effective for reducing side etching in patterning of the solid layer using another mask material described later, and is thus essential step for improving transfer accuracy.

A solid layer can be contacted with a chemical agent by any method; for example, immersing a base structure having a solid layer in a liquid chemical agent (pure material or solution) used for the treatment, adding dropwise a liquid chemical agent to the surface of a base structure having a solid layer and contacting only the solid layer surface with the chemical agent by the action of surface tension, and applying a liquid chemical agent to the surface of a solid layer by spraying. Here, vibration may be applied for ensuring adequate contact of the chemical agent with the surface of the solid layer (including the surface of the inter-particulate void). There are no particular restrictions to a treatment temperature; for example, 0 °C to 150 °C, generally room temperature (about 10 °C to about 35 °C) to 100 °C.

A treatment time (contacting time) can be appropriately selected, depending on a chemical agent used and a contacting method, but since a too long time may cause deterioration in productivity, the time is generally about 1 sec to about 1 hour, preferably about 10 sec to about 20 min.

After contacting with a chemical agent, the chemical agent may be dried in situ when the chemical agent is a volatile material. When the agent is not volatile, generally carried out is washing with water (for a water-soluble agent) and/or an organic solvent (for an organic-solvent soluble agent) for preventing the agent from interfering with the subsequent steps ((c) forming a resist mask (for etching a solid layer) and (d) etching a solid layer). After washing with water and/or an organic solvent and drying, the next step of forming a resist mask (for etching the solid layer) follows. The drying may be conducted by, for example, spin drying or dry-air spraying.

A chemical agent which can be used for the treatment can be selected from various materials, compounds and compositions of these. Any material may be effective as long as it is at least liquid and can be contacted with the solid layer, that is, a material capable of wetting at least the solid layer, although a material obviously dissolving the solid layer such as an etchant is excluded. Although details are uncertain, the effect would be achieved by chemical and/or physical modification (including coating) caused on the surface of the solid layer (including the surface of the inter-particulate void) by contacting with a liquid chemical agent.

The analysis results indicate that between before and after the treatment with a chemical agent, concentrations of carbon, oxygen and hydrogen are significantly changed, and it could be, therefore, speculated that the treatment with a chemical agent would cause (1) adhesion of the chemical agent (and/or its dissociation product) to the surface of the solid layer, (2) elimination of the surface atom/atomic group/molecule in the solid layer, and (3) chemical modification of the surface atom/atomic group/molecule in the solid layer, alone or in combination, resulting in modification of the surface of the solid layer. Also variation in the shape of the fine particles has been observed, depending on the type of the chemical agent (in the case of an alkaline solution described later), and thus physical effects could be speculated. Since the solid layer is a collection of bounded fine particles, the surface would be significantly influential.

Although the mechanism of reduction in side etch is also unclear and a matter for speculation, it can be speculated that improvement in resistance to an etchant, improvement in the effect of etchant repelling (hydrophobicity), improvement in affinity and/or permeability to a photoresist and the effect of preventing fine particle detachment occur alone or in combination, depending on a chemical agent used in the treatment.

Specific examples of a chemical agent used in the treatment include water, organic acids, alkaline solutions, organic solvents and hydrophobizing agents. A solid can be used as a solution. When a chemical agent other than water or a volatile organic solvent is used, the product is generally washed with water or an organic solvent. In comparison with water or an organic solvent (for washing), there are cases including the case that the effect is larger (the effect of the chemical agent is significant), the case that the effect is substantially comparable (the effect of water or an organic solvent (for washing) is supposed to be predominant) and the case that the effect is less (the effect of water or an organic solvent (for washing) does not appear).

When water is used as a chemical agent, it is preferable to use deionized water from which, for example, alkali metal ions such as Na ions have been removed, distilled water or extra-pure water. When water is used, the treated solid layer may be just dried.

An organic acid preferably used has a carboxylic group (-COOH). Specific examples include monocarboxylic acids having 1 to 40, preferably 1 to 20 carbon atoms such as formic acid, acetic acid, propionic acid, n-butyric acid, isobutyric acid, caproic acid, undecylic acid, lauric acid, palmitic acid and stearic acid and unsaturated acids having an unsaturated bond in the chain such as oleic acid; saturated and unsaturated dicarboxylic acids such as oxalic acid, malonic acid, succinic acid, glutaric acid, adipic acid, sebacic acid, maleic acid, fumaric acid and itaconic acid; carboxylic acids having three or more intra-molecular COOH groups; hydroxy acids such as glycolic acid, lactic acid, tartronic acid, glyceric acid, malic acid, tartaric acid, citramalic acid, citric acid, isocitric acid, leucine acid, mevalonic acid, pantoic acid, gluconic acid, saccharic acid, recinoleic acid, ricinelaidic acid, cerebronic acid, quinic acid and shikimic acid; and aromatic carboxylic acids such as benzoic acid and salicylic acid.

The organic acid preferably meets at least one of the following conditions: (1) a molecular weight of 120 or more (generally preferably having 40 or less carbon atoms), (2) solid at an ambient temperature, and (3) water-soluble. Particularly preferred is a carboxylic acid having intramolecular COOH and OH, that is, a hydroxy acid.

The organic acid may be a free acid or in a form of salt. When being a salt, it is preferably an alkali metal salt or an ammonium salt, particularly an ammonium salt. In general, a free acid is more preferable.

Furthermore, a water-soluble organic acid exhibiting a high solubility is preferable; for example, organic acids having a solubility of 1 % by weight or more, preferably 5 % by weight or more, more preferably 10 % by weight or more, particularly preferably 20 % by weight or more. If an organic acid contains stereoisomers, it is preferable to use a stereoisomer having a larger solubility. For example, for tartaric acid, d-, l- and meso-forms are preferable and a racemate is less useful due to its lower solubility.

There are no particular restrictions to a concentration of an organic acid solution (preferably, an aqueous solution) used in the treatment; for example, 0.1 % by weight or more, and for clearly achieving the effects of the organic acid, preferably 1 % by weight or more, more preferably 5 % by weight or more, further preferably 10 % by weight or more, particularly preferably 20 % by weight or more. A concentration close to a saturated solution is more preferable. Generally, the solution having a concentration equal to or less than a saturated concentration is used.

When an organic acid or an organic acid solution is used as a chemical agent, then it is preferable to conduct washing with water and/or an organic solvent. When a water-soluble organic acid which is a preferable chemical agent is used, then it is preferable to conduct washing with water.

An alkaline solution may be an alkali itself (when the alkali itself is a liquid), an aqueous solution or a solution in an organic solvent.

Examples of a water-soluble alkali include alkali metal hydroxides, alkaline earth metal hydroxides, ammonia (ammonia water) and primary to quaternary ammonium hydroxides. Examples of an alkali metal hydroxide include sodium hydroxide and potassium hydroxide. An example of an alkaline earth metal hydroxide includes magnesium hydroxide. Among primary to quaternary ammonium hydroxides, particularly preferred is a quaternary ammonium hydroxide; specifically, tetramethylammonium hydroxide, tetraethylammonium hydroxide, tetrapropylammonium hydroxide, trimethylethylammonium hydroxide, trimethyl(2-hydroxyethyl)ammonium hydroxide, triethyl(2-hydroxyethyl)ammonium hydroxide, tripropyl(2-hydroxyethyl)ammonium hydroxide and trimethyl(1-hydroxypropyl)ammonium hydroxide, preferably tetramethylammonium hydroxide and trimethyl(2-hydroxyethyl)ammonium hydroxide.

There are no particular restrictions to a concentration of the alkaline solution (preferably, an aqueous solution); for example, it is 0.1 % by weight or more, and for clearly achieving the effects of the alkaline solution, preferably 1 % by weight or more, more preferably 3 % by weight or more. It is preferably a saturated concentration or less, more preferably 40 % by weight or less.

These alkali can be used in a form other than an aqueous solution; for example, it may be a solution in a lower alcohol such as methanol and ethanol or a solution in a mixture of an alcohol and water.

Furthermore, alkalis which can be used as an alkali solution include an aliphatic amine and an aliphatic amine. An aliphatic amine can be an amine in which at least one of hydrogen atoms in ammonia, $NH_3$, is replaced with alkyl or hydroxyalkyl having 20 or less, preferably 12 or less carbon atoms (an alkylamine or alkylalcoholamine). Specific examples include monoalkylamines such as methylamine, ethylamine, propylamine, butylamine, n-hexylamine, n-heptylamine, n-octylamine, n-nonylamine and n-decylamine; dialkylamines such as diethylamine, di-n-propylamine, di-n-heptylamine and di-n-octylamine, dicyclohexylamine; trialkylamines such as trimethylamine, triethylamine, tri-n-propylamine, tri-n-butylamine, tri-n-hexylamine, tri-n-pentylamine, tri-n-heptylamine, tri-n-octylamine, tri-n-nonylamine, tri-n-decanylamine and tri-n-dodecylamine; and alkylalcoholamines such as monoethanolamine, diethanolamine, triethanolamine, diisopropanolamine, triisopropanolamine, di-n-octanolamine and tri-n-octanolamine. An aromatic amine can be an amine in which at least one of hydrogen atoms in ammonia, $NH_3$, is replaced with aryl (preferably phenyl) or arylalkyl having 20 or less, preferably 12 or less carbon atoms; specific examples include primary amines such as benzylamine, phenylamine (aniline) and phenetylamine; secondary amines such as dibenzylamine, diphenylamine, diphenetylamine, N-methylaniline and N-methyl-p-toluidine; tertiary amines such as triphenylamine, tribenzylamine, triphenetylamine, N,N'-dimethylaniline and N,N'-dibenzylaniline. These amine compounds can be used as they are or as solutions in which they are dissolved or diluted in organic solvent(s).

Most preferable examples of the alkaline solution include aqueous solutions of alkylammonium hydroxide such as tetramethylammonium hydroxide and trimethyl(2-hydroxyethyl)ammonium hydroxide, and an aqueous solution of alkali metal hydroxide such as sodium hydroxide.

Examples of an organic solvent which can be used in the treatment with a chemical agent include aliphatic and aromatic hydrocarbons, alcohols, ketones, esters, ethers and non-aqueous polar solvents.

As aliphatic and aromatic hydrocarbons, those in liquid state is used. examples include saturated or unsaturated aliphatic hydrocarbons having preferably 5 or more and preferably 20 or less carbon atoms such as pentane, hexane, heptane and octane, and aromatic hydrocarbons such as benzene, toluene and xylene. Furthermore, hydrocarbon mixtures such as petroleum ether, mineral spirits, petroleum benzine and kerosene can be used.

Examples of an alcohol include aliphatic monoalcohols having preferably about 20 or less carbon atoms such as methanol, ethanol, n-propylalcohol, iso-propylalcohol, octanol and decanol, and polyols such as ethylene glycol, propylene glycol, butanediol, glycerol and polyoxyethylene. In the polyol, OH groups may be partly etherified or esterified, and examples of an etherified compound include (poly)alkyleneglycol monoalkyl ethers such as ethylene glycol monomethyl ether, ethylene glycol monoethyl ether, ethylene glycol mono-n-propyl ether, ethylene glycol mono-n-butyl ether, diethylene glycol monomethyl ether, diethylene glycol monoethyl ether, diethylene glycol mono-n-propyl ether, diethylene glycol mono-n-butyl ether, triethylene glycol monomethyl ether, triethylene glycol monoethyl ether, propylene glycol monomethyl ether, propylene glycol monoethyl ether, propylene glycol mono-n-propyl ether, propylene glycol mono-n-butyl ether, dipropylene glycol monomethyl ether, dipropylene glycol monoethyl ether, dipropylene glycol mono-n-propyl ether, dipropylene glycol mono-n-butyl ether, tripropylene glycol monomethyl ether and tripropylene glycol monoethyl ether. Examples of an aromatic alcohol include benzyl alcohol, methylbenzyl alcohol, p-isopropylbenzyl alcohol, 1-phenylethanol, phenetyl alcohol, 1-phenyl-1-propanol, cinnamyl alcohol, xylene-$\alpha,\alpha'$-diol, salicyl alcohol, p-hydroxybenzylalcohol and anisyl alcohol.

Examples of a ketone include ketones having preferably 20 or less, more preferably 10 or less carbon atoms such as acetone, methyl ethyl ketone, diethyl ketone, cyclohexanone, methyl isoamyl ketone and 2-heptanone.

Examples of an ester include alkyl esters (having preferably 20 or less, further preferably 12 or less carbon atoms) such as ethyl acetate, n-propyl acetate, i-propyl acetate, n-butyl acetate, i-butyl acetate, n-pentyl formate, i-pentyl acetate, n-butyl propionate, ethyl butyrate, n-propyl butyrate, 1-propyl butyrate and n-butyl butyrate; alkyl lactates such as methyl 2-hydroxypropionate, ethyl 2-hydroxypropionate and butyl 2-hydroxypropionate; substituted alkyl esters having alkoxy or oxyalkyl (compounds having preferably 20 or less, further preferably 12 or less carbon atoms) such as ethyl 2-hydroxy-2-methylpropionate, methyl 3-methoxypropionate, ethyl 3-methoxypropionate, methyl 3-ethoxypropionate, ethyl 3-ethoxypropionate, ethyl ethoxyacetate, ethyl hydroxyacetate, methyl 2-hydroxy-3-methylbutanoate, 3-methyl-3-methoxybutyl acetate and 3-methyl-3-methoxybutyl propionate; other esters such as methyl pyruvate, ethyl pyruvate, n-propyl pyruvate, methyl acetoacetate, ethyl acetoacetate and ethyl 2-oxobutanoate; and (poly)alkylene glycol monoalkylether acetates such as ethylene glycol monomethyl ether acetate, ethylene glycol monoethyl ether acetate, diethylene glycol monomethyl ether acetate, diethylene glycol monoethyl ether acetate, propylene glycol monomethyl ether acetate and propylene glycol monoethyl ether acetate.

Examples of an ether include linear or branched-chain dialkyl ethers such as dimethyl ether and diethyl ether; and cyclic ethers such as tetrahydrofuran, tetrahydropyrane, oxetane and dioxane.

Examples of an non-aqueous polar solvent include sulfur-containing compounds such as dimethyl sulfoxide (DMSO) and sulfolane; and nitrogen-containing compounds such as N,N-dimethylacetamide, N,N-dimethylformamide (DMF) and N-methyl-2-pyrrolidone.

Examples of a hydrophobizing agent include silazanes such as hexamethylsilazane; alkoxy silanes such as dimethyldimethoxysilane; and compounds known as a silane coupling agent including vinylsilanes such as vinyltris(β-methoxyethoxy)silane, vinylethoxysilane and vinyltrimethoxysilane, (meth)acrylsilanes such as γ-methacryloxypropyltrimethoxysilane, epoxy silanes such as β-(3,4-epoxy-cyclohexyl)ethyltrimethoxysilane, β-(3,4-epoxy-cyclohexyl)methyltrimethoxysilane, β-(3,4-epoxy-cyclohexyl)ethyltriethoxysilane, γ-glycidoxypropyltrimethoxysilane and γ-glycidoxypropyltriethoxysilane, aminosilanes such as N-β-(aminoethyl)-γ-aminopropyltriethoxysilane, N-β-(aminoethyl)γ-aminopropyltrimethoxysilane, N-β(aminoethyl)-γ-aminopropylmethyldiethoxysilane, γ-aminopropyltriethoxysilane, γ-aminopropyltrimethoxysilane, N-phenyl-γ-aminopropyltrimethoxysilane and N-phenyl-γ-aminopropyltriethoxysilan, and thiosilanes such as γ-mercaptopropyltrimethoxysilane and γ-mercaptopropyltriethoxysilane.

The hydrophobizing agents can be used as they are or as solutions in which they are dissolved in organic solvent(s).

As the properties of effective chemical agents in the present invention, (1) property improving affinity and/or permeability of the solid layer with the resist, and (2) property slightly dissolving the solid layer are raised, but not limited to these. Besides the chemical agents listed above, a chemical agent having at least one of these properties can be effective in the treatment with a chemical agent.

For (1) property improving affinity and/or permeability of the solid layer with the resist, among those listed above, organic solvents, organic acids, alkaline solutions and hydrophobizing agents seem to have this property. Water also seems to have this property.

For the property (2)slightly dissolving a solid layer, among those listed above, alkaline solutions and at least some of organic acids have this property. When the solid layer is immersed in a chemical agent at room temperature for 3 min, a dissolution ratio is preferably 0.01 % or more, more preferably 0.1 % or more and preferably 45 % or less, more preferably 35 % or less, particularly preferably 10 % or less. It has been observed that among chemical agents capable of slightly dissolving a solid layer, those having higher dissolving power clearly change the shape of fine particles appearing in the surface of the solid layer.

(C) Treatment with a polymer solution

Treatment of a solid layer with a polymer solution

As a third aspect, the solid layer deposited is treated with a polymer solution. This step of treatment with a polymer solution is effective for reducing side etching in patterning of the solid layer using another mask material described later, and is thus essential step for improving transfer accuracy.

The solid layer can be contacted with the polymer solution by any method; for example, immersing a base structure having a solid layer in a polymer solution, adding dropwise a polymer solution to the surface of a base structure having a solid layer and contacting only the solid layer surface with the polymer solution by the action of surface tension, and applying a polymer solution to the surface of a solid layer by spraying. For temporarily forming a polymer layer on a base structure, a coating method such as spin coating, screen printing, dip coating, spray coating, curtain coating, slit coating, roll coating and dispenser application can be employed. Here, vibration may be applied for ensuring adequate contact of the polymer solution with the surface of the solid layer (including the surface of the inter-particulate void). There are no particular restrictions to an application temperature as long as a polymer solution can be applied and can be determined, taking a melting point and a boiling point of a solvent contained and the like into consideration, and may be generally about room temperature (about 10 °C to about 35 °C).

After contacting the polymer-solution, the polymer may be on the solid layer in any of various forms from a flowable solution to a substantially solvent-free solid after evaporation of the solvent, depending on the type of the solvent. Then, the step of removing the polymer can be immediately initiated or a solid polymer layer may be formed once by evaporating the solvent by drying.

The drying may be, if conducted, appropriately selected depending on the types of the solvent and the polymer, for example by heating at room temperature (15 to 30 °C) to 200 °C, preferably room temperature to 150 °C. A heating time can be appropriately selected; for example, 10 sec to 1 hour, preferably about 20 sec to 30 min. The heating can be conducted in multiple steps.

Then, the polymer is removed from at least a part of the solid layer or the whole solid layer. For the removing method, the polymer can be removed under a method and conditions which at least do not interfere with the subsequent processes ((c) forming a resist mask (for solid layer etching) and (d) solid layer etching) and allows treatment with a polymer solution to be effective. For example, washing with a solvent, plasma ashing or a combination thereof can be employed. In particular, it is preferable to use a solvent capable of dissolving the polymer. The solvent can be any solvent as long as it does not influence the base structure and can dissolve the remaining polymer. For a polymer soluble in an organic solvent, specific examples include lower alcohols such as methanol, ethanol and isopropyl alcohol (preferably having up to 4 carbon atoms); and ketones such as acetone and methyl ethyl ketone. Two or more organic solvents can be combined and in such a case, they can be mixed and/or sequentially used. After removing the residual polymer with an organic solvent, it is also preferable to wash the solid layer with water. Then, after optional drying, the subsequent step of forming a resist mask (for etching a solid layer) follows. The drying can be conducted by spin drying, dry-air spraying or the like.

A polymer solution which can be used for the treatment with a polymer solution of the present invention as described above contains at least a polymer and a solvent capable of dissolving the polymer. The term, "polymer" as used herein includes thermoplastic resins and thermosetting resins, and also water-soluble resins such as cellulose derivatives and polysaccharides.

Preferable examples of such a polymer include phenol resins, urea resins, melamine resins, epoxy resins, polyurethanes, polyvinyl chlorides, polystyrene resins, polyamides, polyimides, acrylic resins, polyester resins, ABS resins, polyvinyl alcohols, polyoxyethylenes, cellulose derivatives (methylcellulose, hydroxymethylcellulose and carboxymethylcellulose).

Preferable examples include polymers used as a base resin for a resist material; for example, phenol resins such as phenol novolacs and cresol novolacs; acrylic resins of (co)polymers containing polymethyl methacrylate, hydroxyethyl methacrylate, other poly(meth)acrylate derivatives or the like; and polystyrene resins of (co)polymers containing polystyrene, polyhydroxystyrene, other polystyrene derivatives or the like.

As a solvent dissolving the polymer, an organic solvent and/or water can be appropriately used. Preferable examples of the organic solvent include alcohols, ketones, esters, ethers and non-aqueous polar solvents.

Examples of an alcohol include aliphatic monoalcohols having preferably about 20 or less carbon atoms such as methanol, ethanol, n-propylalcohol, iso-propylalcohol, octanol and decanol, and polyols such as ethylene glycol, propylene glycol, butanediol, glycerol and polyoxyethylene. The alcohol is preferably a polyol or a derivative whose OH groups are partly etherified or esterified. Examples of an etherified compound include (poly)alkyleneglycol monoalkyl ethers such as ethylene glycol monomethyl ether, ethylene glycol monoethyl ether, ethylene glycol mono-n-propyl ether, ethylene glycol mono-n-butyl ether, diethylene glycol monomethyl ether, diethylene glycol monoethyl ether, diethylene glycol mono-n-propyl ether, diethylene glycol mono-n-butyl ether, triethylene glycol monomethyl ether, triethylene glycol monoethyl ether, propylene glycol monomethyl ether, propylene glycol monoethyl ether, propylene glycol mono-n-propyl ether, propylene glycol mono-n-butyl ether, dipropylene glycol monomethyl ether, dipropylene glycol monoethyl ether, dipropylene glycol mono-n-propyl ether, dipropylene glycol mono-n-butyl ether, tripropylene glycol monomethyl ether and tripropylene glycol monoethyl ether. Examples of an aromatic alcohol include benzyl alcohol, methylbenzyl alcohol, p-isopropylbenzyl alcohol, 1-phenylethanol, phenetyl alcohol, 1-phenyl-1-propanol, cinnamyl alcohol, xylene-$\alpha,\alpha$'-diol, salicyl alcohol, p-hydroxybenzylalcohol and anisyl alcohol.

Examples of a ketone include ketones having preferably 20 or less, more preferably 10 or less carbon atoms such as acetone, methyl ethyl ketone, diethyl ketone, cyclohexanone, methyl isoamyl ketone and 2-heptanone.

Examples of an ester include alkyl esters (having preferably 20 or less, further preferably 12 or less carbon atoms) such as ethyl acetate, n-propyl acetate, i-propyl acetate, n-butyl acetate, i-butyl acetate, n-pentyl formate, i-pentyl acetate, n-butyl propionate, ethyl butyrate, n-propyl butyrate, 1-propyl butyrate and n-butyl butyrate; alkyl lactates such as methyl 2-hydroxypropionate, ethyl 2-hydroxypropionate and butyl 2-hydroxypropionate; substituted alkyl esters having alkoxy or oxyalkyl (compounds having preferably 20 or less, further preferably 12 or less carbon atoms) such as ethyl 2-hydroxy-2-methylpropionate, methyl 3-methoxypropionate, ethyl 3-methoxypropionate, methyl 3-ethoxypropionate, ethyl 3-ethoxypropionate, ethyl ethoxyacetate, ethyl hydroxyacetate, methyl 2-hydroxy-3-methylbutanoate, 3-methyl-3-methoxybutyl acetate and 3-methyl-3-methoxybutyl propionate; miscellaneous esters such as methyl pyruvate, ethyl pyruvate, n-propyl pyruvate, methyl acetoacetate, ethyl acetoacetate and ethyl 2-oxobutanoate; and (poly)alkylene glycol monoalkylether acetates such as ethylene glycol monomethyl ether acetate, ethylene glycol monoethyl ether acetate, diethylene glycol monomethyl ether acetate, diethylene glycol monoethyl ether acetate, propylene glycol monomethyl ether acetate and propylene glycol monoethyl ether acetate.

Examples of an ether include linear or branched-chain dialkyl ethers such as dimethyl ether and diethyl ether; and cyclic ethers such as tetrahydrofuran, tetrahydropyrane, oxetane and dioxane.

Examples of an non-aqueous polar solvent include sulfur-containing compounds such as dimethyl sulfoxide (DMSO) and sulfolane; and nitrogen-containing compounds such as N,N-dimethylacetamide, N,N-dimethylformamide (DMF) and N-methyl-2-pyrrolidone.

Although the mechanism of reduction in side etch achievable by treatment with a polymer solution which is characteristic in the present invention is unclear and a matter for speculation, it can be speculated that improvement in resistance to an etchant, improvement in the effect of etchant repelling (hydrophobicity), improvement in affinity and/or permeability to a photoresist (for etching a solid layer) and the effect of preventing fine particle detachment occur alone or in combination.

Patterning of a solid layer

The solid layer treated with a liquid as described above {(A) treatment with a resist composition, (B) treatment with a chemical agent and (C) treatment with a polymer solution} is patterned into a desired shape preferably by etching. This etching of the solid layer is conducted under the conditions where the solid layer can be etched and which are different from the etching conditions for a semiconductor layer, particularly preferably by wet etching using an acid or alkali. In the present invention, side etching of the solid layer is reduced by the above treatment with a liquid.

An etching mask layer including a solid layer is patterned preferably using another mask. For example, as shown in FIG. 3, a resist mask layer 4 made of a photoresist material is formed on the etching mask layer 3, and then the resist mask layer 4 is patterned by common photolithographic technique such as exposure and development as shown in FIG. 4. The photoresist used may be either positive or negative. The photoresist, when a resist composition is employed in the treatment with a liquid, may be identical to or different from the resist material used for the treatment with a liquid.

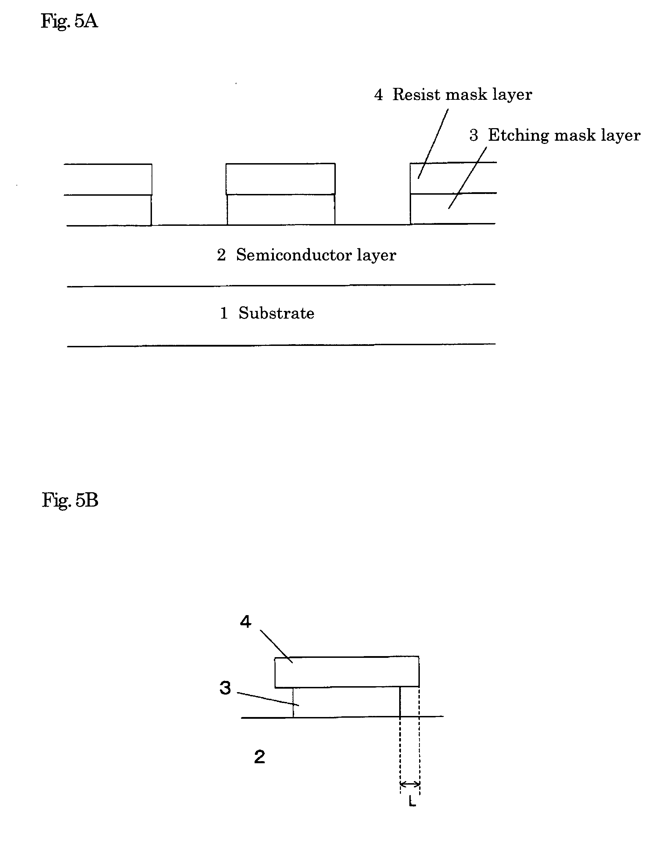

Subsequently, as shown in FIG. 5A, the etching mask layer 3 including the solid layer is etched using the patterned resist mask layer 4 as a mask.

An etchant for wet etching is preferably an aqueous solution containing an acid such as hydrochloric acid, hydrofluoric acid, sulfuric acid, phosphoric acid and nitric acid, and, if necessary, further contains an oxidizing agent such as hydrogen peroxide and/or a diluent such as ethylene glycol. The etchant is selected, taking the solid layer material, deposition conditions and the like into consideration, and particularly preferably contains at least hydrochloric acid, concentrated sulfuric acid, hydrofluoric acid or the like; for example, hydrochloric acid is preferable for patterning $SrF_2$ and concentrated sulfuric acid or hydrochloric acid, particularly concentrated sulfuric acid for patterning $CaF_2$. The etching may be conducted using an alkali, and any etching may be combined with light irradiation, heating or the like.

Wet etching is generally isotropic etching, and therefore, is associated with undesirable side etching. As schematically shown in FIG. 5B, the edge of the etching mask layer 3 including the solid layer recedes from the mask edge of the resist mask layer 4 due to side etching. A receding distance is defined as a side-etching width L. The smaller the side-etching width L is, the more precisely the pattern of the resist mask layer 4 is transferred, allowing for precise patterning.

In the present invention, treating the solid layer with a liquid makes a side-etching width significantly small, so that the etching mask layer 3 including the solid layer can be patterned precisely in accordance with the resist pattern. Therefore, in terms of the shape of the semiconductor layer 2 (= base structure) patterned by etching using the etching mask layer 3 as a mask, the transfer accuracy to the resist pattern is improved.

Furthermore, by the treatment with a liquid, the pattern boundary of the solid layer becomes very sharp after patterning, so that the transfer accuracy can be further improved in dry etching of the base structure using the solid layer as a mask.

In the present invention, when a solid layer having a thickness of about 400 nm is etched, a side-etching width L can be reduced to 6 $\mu$m or less, preferably 4 $\mu$m or less, more preferably 3 $\mu$m or less. Particularly, treatment with a resist composition allows a side-etching width L to be reduced to particularly preferably 2 $\mu$m or less. Furthermore, treatment with a chemical agent allows for a side-etching width L of particularly preferably 2 $\mu$m or less, most preferably 1 $\mu$m or less. Thus, the fine patterning of even a base structure which is difficult to form fine patterning due to relatively resistant to etching like a Group III-V nitride semiconductor becomes possible.

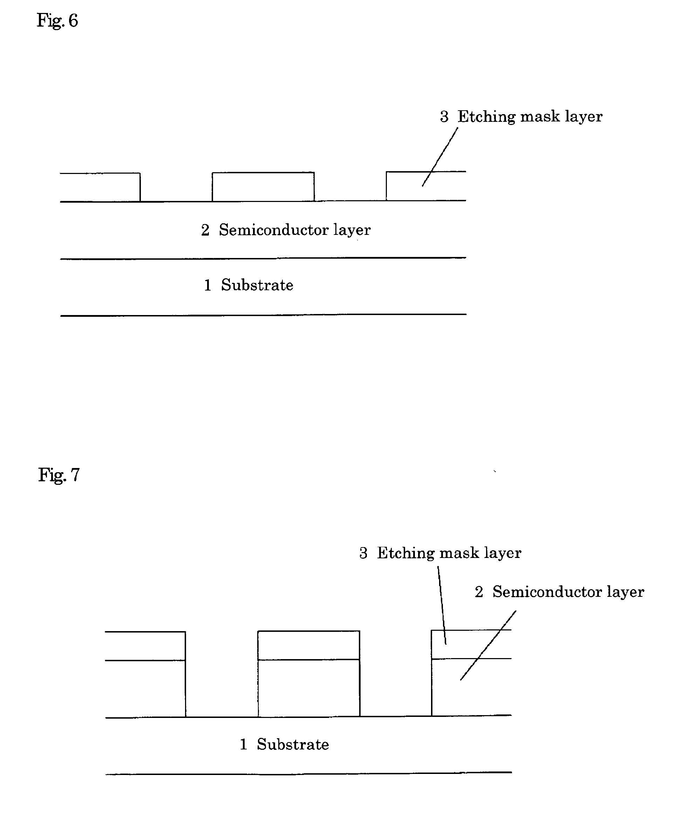

Thus, after wet etching of the etching mask layer 3 is completed and the structure in FIG. 5A is formed, the resist mask layer 4 no longer required is generally removed to obtain the structure in which the patterned etching mask layer 3 has been formed on the semiconductor layer as shown in FIG. 6.

Etching of a semiconductor layer

In the step of etching a semiconductor layer, the semiconductor layer 2 is etched using the etching mask layer 3 as a mask, as shown in FIG. 7.

The semiconductor layer is etched desirably by dry etching. For dry etching, the conditions such as a gas species, a bias power and vacuum degree can be appropriately selected on the basis of a material for the semiconductor layer, crystallinity and other properties. When the semiconductor layer is a Group III-V nitride semiconductor, the gas species for dry etching is preferably a chlorine-containing gas which contains elemental chlorine as a gas component;

and desirably, it is selected from $Cl_2$, $BCl_3$, $SiCl_4$, $CCl_4$ and combinations of these. A chlorine-containing plasma generated from such a gas species allows for large selectivity in dry etching between the GaN material and the material forming the solid layer deposited at a high temperature, and thus, the nitride semiconductor layer can be etched while the material forming the solid layer deposited at a high temperature is little etched. As a result, the semiconductor layer can be etched with excellent shape controllability. During the dry etching, a thickness of the solid layer is not substantially reduced, but the film properties, particularly its resistance to wet etching is changed so that a wet-etching rate tends to be reduced.

During the dry etching, a plasma can be generated by any procedure such as capacity-coupled plasma generation (CCP type), inductively-coupled plasma generation (ICP type) and plasma generation based on electron cyclotron resonance (ECR type). However, in the present invention, it is desirable to generate chlorine-containing plasma by inductively-coupled plasma generation. This is because the approach can obtain a higher plasma density than that in any other approach, which is advantageous in etching a Group III-V nitride semiconductor material or the like. Here, a plasma density during the dry etching is preferably $0.05 \times 10^{11}$ (cm$^{-3}$) to $10.0 \times 10^{11}$ (cm$^{-3}$), more preferably $1 \times 10^{11}$ (cm$^{-3}$) to $7.0 \times 10^{11}$ (cm$^{-3}$). Furthermore, the solid layer deposited at a high temperature in the present invention has so improved etching resistance that it can exhibit adequate resistance even to a plasma with a high plasma density formed by an inductive connection method.

For example, a selection ratio of a mask to a nitride semiconductor layer is about 5 to 20 when using a nitride or oxide such as $SiN_x$ and $SiO_x$ or metal such as Ni as a mask. On the other hand, the solid layer mask of the present invention can give a selection ratio of 100 or more even to a nitride semiconductor layer. Therefore, the method of the present invention is particularly preferably used for deeply etching a Group III-V nitride semiconductor layer. For a Group III-V nitride semiconductor layer, the present invention can be applied to an etching depth of 1 $\mu$m or more, preferably 2 $\mu$m or more, more preferably 3 $\mu$m or more, most preferably 5 $\mu$m or more, even more than 10 $\mu$m. Furthermore, if an adequately thick $SrF_2$ mask is formed before the etching of the semiconductor layer, a very thick layer can be etched although it depends on a material for the solid layer mask, a thickness and a material for the semiconductor layer. A thickness of the semiconductor layer to be etched is generally 50 mm or less, preferably 35 mm or less, more preferably 5 mm or less, further preferably 1 mm or less, most preferably 500 $\mu$m or less. As examples of etching of an extremely thick semiconductor layer, there are exemplified a case where a thick GaN substrate with a thickness of about 3 mm to 35 mm is etched using an $SrF_2$ mask and a case where most of the thickness of the substrate and thin-film crystal growth layers of a GaN epitaxial layer and the like grown on the substrate are simultaneous etched. It is, of course, possible that only a thin-film crystal growth layer with a thickness of about 7 $\mu$m is etched without the substrate being etched. In such a case, a large selection ratio allows for reducing a trench width formed by etching as appropriate; for example, it may be reduced to 100 $\mu$m or less, preferably 10 $\mu$m or less, further preferably 3 $\mu$m or less. An aspect ratio of a trench depth to a trench opening width (depth/width) can be appropriately selected; even for a Group III-V nitride semiconductor layer, the aspect ratio of 0.1 or more, preferably 2 or more is possible, and up to about 50, for example, up to about 30 is possible.

An etching depth of the semiconductor layer in the present invention can be appropriately selected, and although FIG. 7 shows a case where the semiconductor layer is totally etched to the substrate, the semiconductor layer may be etched to its middle and a part of the substrate, which may be a non-semiconductor material such as sapphire, may be continuously etched by varying an etching gaseous species or the like. The extent of the etching or a layer constituting the semiconductor layer to which the etching reaches can be appropriately selected.

After completing etching of the semiconductor layer as shown in FIG. 7, if necessary, the etching mask layer may be removed, or a different process may be initiated while retaining the etching mask layer. Generally, it is preferable to remove the etching mask layer.

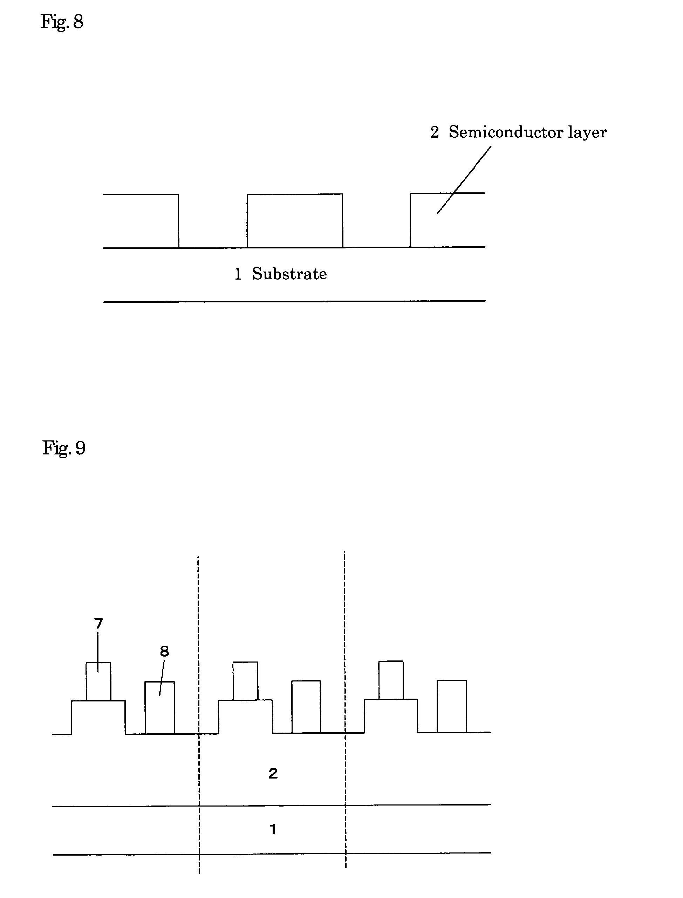

FIG. 8 shows a structure after removing the etching mask layer 3. Any method may be employed for removing the solid layer constituting the etching mask layer 3; for example, the solid layer may be removed by an etchant containing an acid or alkali. In the afore-mentioned step of patterning the solid layer, the conditions are selected such that the solid layer is easily etched while a semiconductor layer is resistant to etching. Here, in the step of removing the solid layer, similar conditions to those in the patterning step may be employed.

An etchant for wet etching is, therefore, preferably an aqueous solution containing an acid such as hydrochloric acid, hydrofluoric acid, sulfuric acid, phosphoric acid and nitric acid, and, if necessary, further contains an oxidizing agent such as hydrogen peroxide and/or a diluent such as ethylene glycol. The etchant is selected, taking the solid layer material, deposition conditions and the like into consideration, and particularly preferably contains at least hydrochloric acid, concentrated sulfuric acid, hydrofluoric acid or the like. For example, hydrochloric acid is preferable for removing $SrF_2$. Concentrated sulfuric acid or hydrochloric acid, particularly concentrated sulfuric acid is preferable for removing $CaF_2$. The removal may be conducted using an alkali, and any etching may be combined with light irradiation, heating or the like for accelerating the reaction or improving selectivity.

In the solid layer after being used as a mask layer during dry etching of the semiconductor layer, a wet-etching rate tends to be reduced, that is, solubility in an etchant tends to be reduced, and therefore, it is preferable to determine the individual conditions in the overall process, taking these into account.

Although the etching mask layer no longer necessary is removed as described above, the etching mask layer may be used, for example, as a mask for selective growth instead of being removed, to form a further semiconductor layer. In particular, when epitaxial growth is conducted, a metal-fluoride material such as $SrF_2$ may be also used as a mask for selective growth.

Description of another embodiment

There will be described one particular embodiment of the present invention. In this embodiment, an etching method of the present invention is applied to a structure where, as shown in FIG. 9, the semiconductor layer 2 over the substrate 1 already has a step and then electrodes 7 and 8 of a metal layer are formed over the semiconductor layer.

When a semiconductor layer having a metal layer such as an electrode and an wiring made of, for example, aluminum is etched by the etching method of the present invention, removal of a solid layer after completion of the etching may lead to erosion and removal of the metal layer such as an electrode and an wiring by an etchant containing an acid or alkali. In such a case, it is preferable that the etching mask layer has a multilayer structure having a solid layer and a second mask layer other than the solid layer. Here, it is, as described above, preferable that the second mask layer is a layer made of a material other than the material for the solid layer, which is resistant to the etchant for etching the solid layer. Furthermore, the second mask layer must be removed under the conditions where a metal layer is not eroded. Examples of the second mask layer include an oxide such as $SiO_x$, $AlO_x$, $TiO_x$, $TaO_x$, $HfO_x$ and $ZrO_x$; a nitride such as $SiN_x$ and $AlN_x$; and combination of these. These are very preferable because they are wet-etching resistant while being finally removable by dry etching by which a metal is not etched. $SiN_x$ and $SiO_x$ are particularly preferable because they can be relatively easily manufactured, especially $SiN_x$.

For example, there will be described a case where a solid layer is made of metal fluoride.

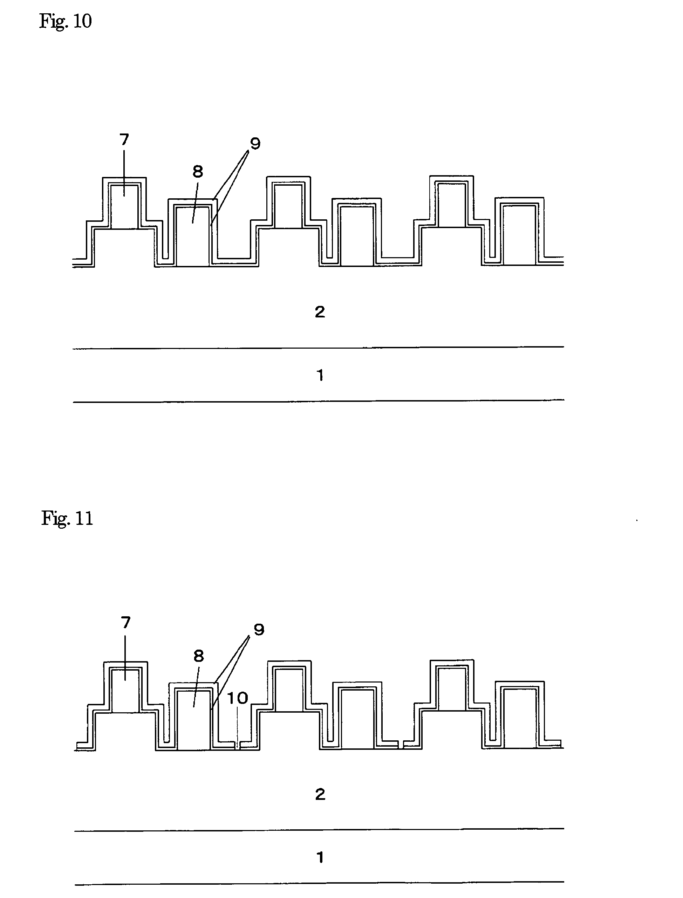

FIG. 10 shows a state where an etching mask layer 9 having a multilayer structure of a layer other than a metal-fluoride such as $SiN_x$ and metal-fluoride layers are formed, in this order from the side of the semiconductor layer, on the semiconductor layer 2 having metal layers (electrodes 7,8).

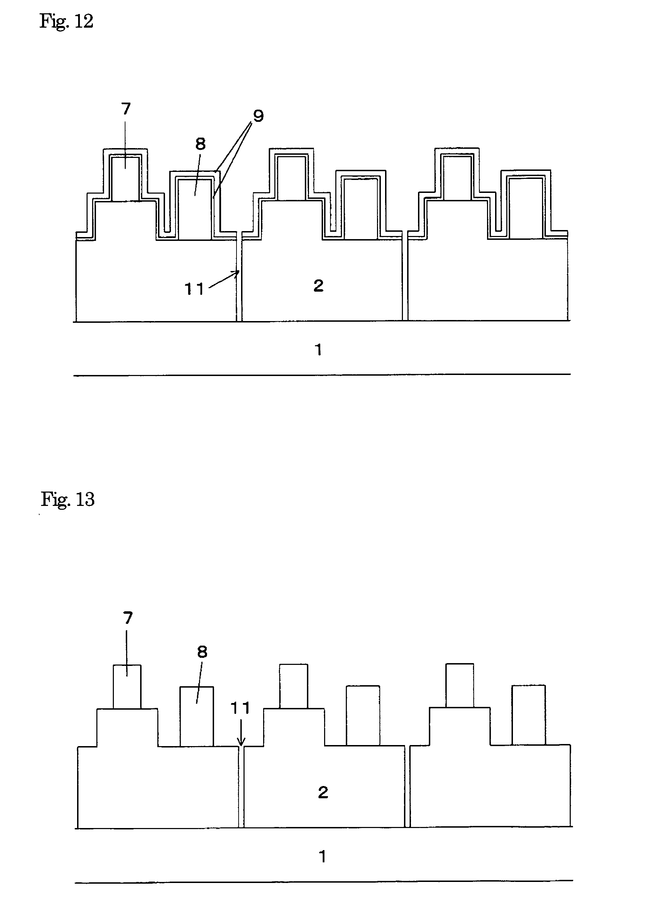

Generally, in this state, treatment with a liquid {(A) treatment with a resist composition, (B) treatment with a chemical agent, (C) treatment with a polymer solution, or the like} is conducted. The treatment conditions can be those as described for the case where the etching mask layer is a monolayer of a metal fluoride layer. Since side etching is reduced by treating the metal fluoride layer with a liquid, pattern accuracy is improved when an opening 10 shown in FIG. 11 is formed. Furthermore, when the semiconductor layer 2 is dry-etched, the superficial metal fluoride layer acts as a mask as shown in FIGs. 11 and 12.

Then, for removing the etching mask layer 9, first the metal-fluoride layer is removed by an acid or alkali while the electrodes 7, 8 made of, for example, aluminum are protected by the second mask layer other than a metal-fluoride such as $SiN_x$. Then, the layer other than a metal-fluoride such as $SiN_x$ can be removed by dry etching without the metal layer being eroded, to give the structure shown in FIG. 13.

In the above case, only a part of the etching mask layer, for example, the part upper the metal layer (for example, electrodes 7, 8) may be formed as a multilayer structure while the part upper the portion other than the metal layer may be formed as a single layer. Furthermore, a multilayered etching mask layer may be used in any step in the manufacturing process of a semiconductor device; it is particularly desirably used in the light of consistency of the whole process.

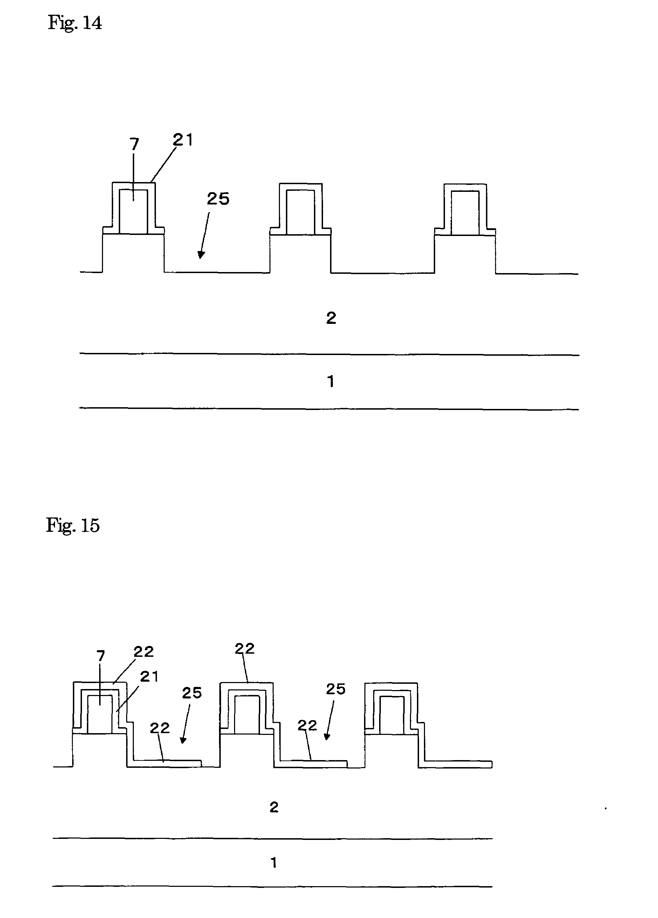

There will be illustrated an example where etching is conducted using an etching mask partially having a multilayer structure in consideration with process consistency. First, FIG. 14 shows the state where a second etching mask 21 made of a mask material other than a metal-fluoride is formed and the semiconductor layer 2 formed over the substrate 1 is etched to form a concave 25. The second etching mask 21 is made of, for example, $SiN_x$, masking an area including a metal layer (electrode 7). An area which is not covered by the second etching mask 21 is etched to form a concave 25. Even when the semiconductor layer 2 is made of a material resistant to etching such as GaN, a known mask material such as $SiN_x$ may be satisfactorily used in the etching when the concave 25 is shallow.

Next, when deep etching is conducted using the metal-fluoride layer as a mask, a metal-fluoride mask 22 is formed without removing the second etching mask 21 as shown in FIG. 15. Thus, the semiconductor layer surface over the metal layer (electrode 7) and its adjacent area have a two-layer structure of the metal-fluoride mask and the second etching mask. This metal fluoride mask 22 is treated with a resist composition before being patterned by etching, and then patterned using an etching mask patterned in accordance with a common photoresist process.

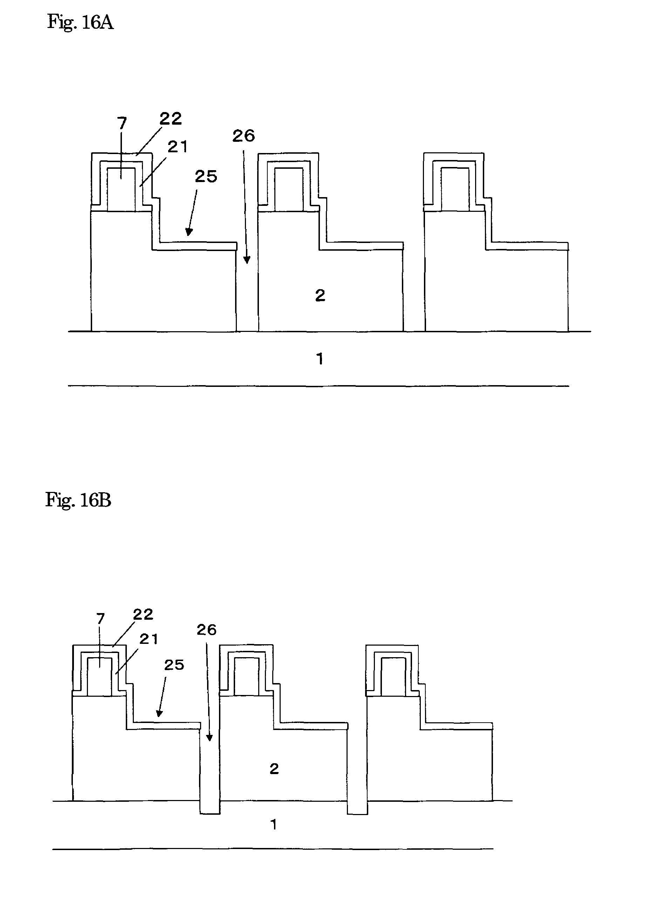

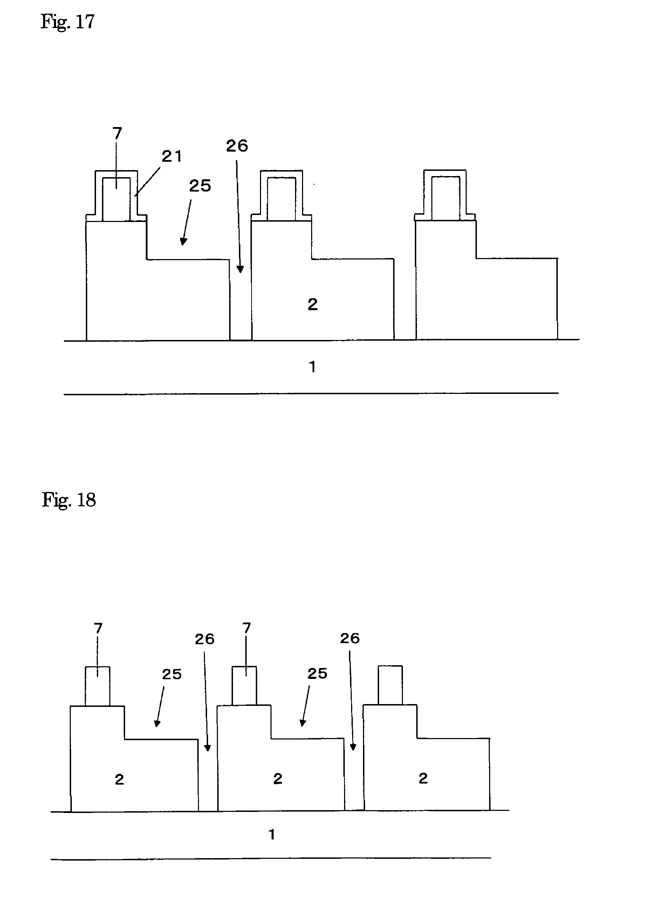

Next, as shown in FIG. 16A, the semiconductor layer 2 is deep-etched using the metal fluoride mask 22 as a mask, to form a trench 26. As described above, the metal fluoride layer has a high dry etching resistance, allowing for deep etching. Here, as shown in FIG. 16B, etching can be conducted including the substrate 1, which is also one preferred aspect (the same holds for other embodiment and examples). Next, the metal-fluoride mask 22 is removed by, for example, an acid to leave the second etching mask 21 as shown in FIG. 17. Thus, the metal layer is not eroded during removal of the metal-fluoride mask 22 by wet etching. Finally, the second etching mask 21 is removed by such a method that the metal layer (electrode 7) or the semiconductor layer is not damaged, whereby providing a structure having a shallow concave 25 and a deep trench 26 in the semiconductor layer 2 as shown in FIG. 18. Such a method may be selected depending on, for example, a material for the semiconductor layer and a material for the metal layer; for example, when the surface of the metal layer is made of Al, the semiconductor layer is a GaN layer and the second etching mask is made of $SiN_x$, it is preferable to conduct dry etching such as reactive ion etching using a fluorine-containing gas as a reactive gas. Thus, in a manufacturing process for a semiconductor device including a first etching step of shallowly etching a semiconductor layer and a second etching step of deeply etching the semiconductor layer, the manufacturing process may be simplified while effectively protecting a metal layer by conducting etching using the second mask other than a metal-fluoride as a mask in the first etching step and then, without removing the mask, forming a metal-fluoride mask layer over the surface in the second etching step to provide a multilayer structure over a partial or the whole area.

Furthermore, in the present invention, forming of a metal-fluoride layer by vacuum evaporation, particularly a method employing heating such as resistance heating without directly colliding charged particles such as electrons and plasma is preferable because dissociation of the metal material and fluorine is prevented, and for further improving step coverage, particularly sidewall coverage, it is also preferable to employ a multilayer structure as described above as an etching mask layer.

For example, an oxide or nitride layer formed by plasma CVD exhibits excellent sidewall coverage for a substrate having a step. Examples of such a layer include oxides such as $SiO_x$, $AlO_x$, $TiO_x$, $TaO_x$, $HfO_x$ and $ZrO_x$; nitrides such as $SiN_x$ and $AlN_x$; and combinations of these. In the light of relatively easier production, $SiN_x$ and $SiO_x$ are particularly preferable, especially $SiN_x$.

As described above, forming an etching mask layer as a multilayer structure of a metal-fluoride layer and a layer other than a metal-fluoride layer is preferable in the light of both protection of a metal layer and step coverage. In particular, taking process consistency into account, a partially multilayered mask can be employed to simplify a manufacturing process while protecting a metal layer.

The etching method of the present invention as described above may be applied to manufacturing a variety of semiconductor devices and can be used in the etching step in the semiconductor manufacturing process.

As described above, an etching mask of the present invention is significantly compatible to etching methods and semiconductor manufacturing processes.

EXAMPLES

There will be more specifically described the present invention with reference to Experimental Examples. The materials, the amounts, the proportions, the treatments, the treating procedures and the like described for the following experiments, examples and reference examples can be appropriately modified without being deviated from the concept of the invention. The scope of the invention should not be interpreted to be limited to the specific examples below. In addition, in the drawings referred in the following examples and reference examples, some sizes are deliberately changed for more clearly understanding the structures, but practical dimensions are as indicated in the following description.

<<Reference Example 1>>

On an Si-doped GaN semiconductor layer grown on a sapphire substrate by MOCVD was vacuum-evaporated an $SrF_2$ film at various substrate temperatures by resistance heating. The $SrF_2$ film thus formed was scrutinized for properties for dry etching of a GaN layer, such as patterning properties as an etching mask, resistance during dry etching and wet etching properties during a subsequent removal process.

The $SrF_2$ film after deposition was patterned by wet etching at room temperature by an etchant of a 1:10 (by volume) mixture of hydrochloric acid (hydrogen chloride content: 36 %) and water using a resist mask, and the etching rate, linearity of the sidewall in the $SrF_2$ film pattern formed and controllability of an absolute value of an opening width were evaluated. The pattern used herein is in a stripe shape, and the transfer accuracy from the planer shape of the resist to the planer shape of $SrF_2$ is evaluated by observing the linearity of the sidewall. Furthermore, the $SrF_2$ mask thus patterned was used for dry etching of the Si-doped GaN layer by $Cl_2$ plasma, and the $SrF_2$ mask was evaluated for compatibility during dry etching. Furthermore, for an etchant containing hydrochloric acid (hydrogen chloride content: 36 %) and water (1:10 by volume), an etching rate at room temperature during the removal step was determined for the $SrF_2$ film subjected to dry etching history by chlorine plasma of the Si-doped GaN semiconductor layer.

Furthermore, during depositing $SrF_2$, in the same chamber was placed a sample in which on the Si-doped GaN semiconductor layer was formed a Ti/Al/Au metal film on which was further formed an $SiN_x$ film, and resistance of the metal electrode part to heat history and change in the surface state during $SrF_2$ mask formation were observed. The metal surface state was observed after forming the $SrF_2$ film, removal of the $SrF_2$ film and removal of the $SiN_x$ film.

Table 1 shows the etching rates observed and the evaluation results.

Table 1

Table 1: Properties of SrF$_2$ films deposited at various substrate temperatures

| Deposition temp. (°C) / Evaluated properties | T<150 | 150≤T<250 | 250≤T<300 | 300≤T<350 | 350≤T<450 | 450≤T≤480 | 480<T |
|---|---|---|---|---|---|---|---|
| Etching rate (without chlorine plasma history) | Excessively and extremely fast 243.3 nm/sec at 50 °C | Fast 11.6 nm/sec at 150 °C | Substantially proper rate 9.8 nm/sec at 250 °C | Substantially proper rate 9.0 nm/sec at 300 °C | Good (slightly slow) 5.1 nm/sec at 350 °C 3.1 nm/sec at 400 °C | Good (slower) 2.83 nm/sec at 450 °C 2.8 nm/sec at 480 °C | Good (slower) 2.75 nm/sec at 500 °C |
| Sidewall shape (without chlorine plasma history) | Extreme irregularity | Irregularity, but practically useable | Improved irregularity | Good linearity is ensured | Better linearity is ensured | Better linearity is ensured | Better linearity is ensured |
| Width controllability (without chlorine plasma history) | None | Slightly bad, but practically useable | Improved width controllability | Improved width controllability | Good | Better | Better |
| Compatibility to dry etching | Bad, mask detachments are observed on some areas | Slightly bad, but practically useable | Good | Good | Good | Good | Good |
| Etching rate (after chlorine plasma history) | Excessively fast 38.5 nm/sec at 50 °C | Substantially proper rate 9.5 nm/sec at 150 °C | Good (slightly slow) 6.5 nm/sec at 250 °C | Good (slightly slow) 4.4 nm/sec at 300 °C | Good (slower) 3.2 nm/sec at 350 °C 2.7 nm/sec at 400 °C | Slow, but practically usable 2.25 nm/sec at 450 °C 2.05 nm/sec at 480 °C | Excessively slow 1.56 nm/sec at 500 °C |
| Metal surface change | None | None | Slightly rough | Rough | Rougher | Significantly rough, but practically usable | Too rough to be used as a device |

Table 1 shows that an SrF$_2$ film deposited at a substrate temperature of 150 °C or higher is suitable as an etching mask for dry etching. Furthermore, it can be understood that an SrF$_2$ film deposited at a substrate temperature of 480 °C or lower is preferable in the light of removal of the SrF$_2$ film at a practical rate after dry etching and the case where there is a metal layer as an underlying layer.

<<Experiment A1>>

Example A1

As described for Reference Experiment 1, on an Si-doped GaN semiconductor layer grown on a sapphire substrate by MOCVD was deposited an SrF$_2$ layer to 400 nm by vacuum deposition using resistance heating at a base structure temperature of 450 °C. The surface state of the SrF$_2$ layer was observed by scanning electron microscopy (SEM) The results are shown in FIG. 26. As seen from FIG. 26, inter-particulate voids are observed in the SrF$_2$ layer of a solid layer and its surface porosity was about 2.7 %. Then, the base structure having the deposited SrF$_2$ layer except the region observed by SEM was placed on a spin coater, and a positive photoresist solution (OFPR-800LB (trade name), from Tokyo Ohka Kogyo Co., Ltd.) was dropped on the deposited SrF$_2$ layer, which was then spin-coated to form a coating film of the resist composition. Then, the product was heated at 85 °C for 15 min (the first heating step) and then without exposure, heated at 120 °C for 15 min (the second heating step). Subsequently, the product was sequentially washed with acetone, isopropanol and then water for three minutes for each procedure.

After drying at room temperature, for patterning the SrF$_2$ layer, a positive photoresist composition (MCPR2200X, from Rohm and Haas Company) was spin-coated on the SrF$_2$ layer, which was then pre-baked and exposed through a photomask having a predetermined pattern. After post-exposure baking, the product was developed and washed and post-baked to complete the patterning of the photoresist. Then, using the etchant as described for Reference Experiment 1, the SrF$_2$ layer was wet-etched at room temperature for 3 min.

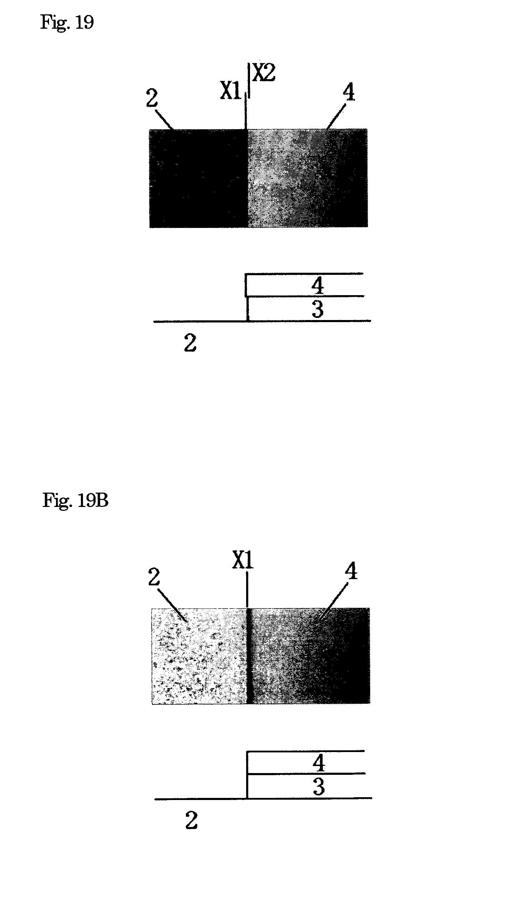

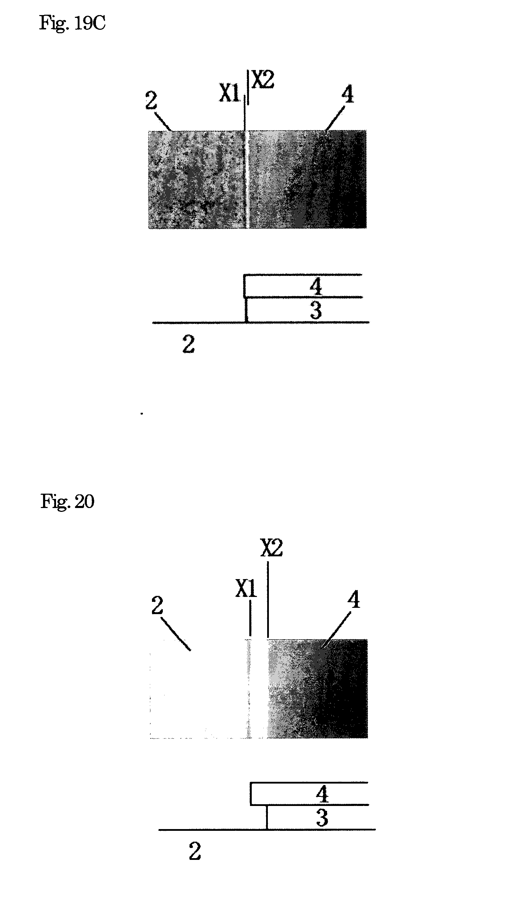

After the wet etching, a side-etching width L was observed by an optical microscopy. As shown in a microscopy image of FIG. 19, the boundary X2 of the SrF$_2$ layer 3 was slightly recessed from the boundary X1 of the photoresist film 4, and the side-etching width L was 0.6 μm.

Reference Example A1

The procedure of Example A1 was conducted without the treatment with a resist composition in Example A1.

As shown in a microscopy image of FIG. 20, the boundary X2 of the $SrF_2$ layer 3 was recessed from the boundary X1 of the photoresist film 4, and the side-etching width L was 7.1 $\mu$m. FIG. 22 shows a cleavage surface SEM image of the boundary. The boundary shape was inferior to that of Example A2 (FIG. 21) with respect to sharpness.

Examples A2 to A8

Treatment with a resist composition was conducted as described in Table 2. The results in Example A1 and Reference Example A1 are also shown in the table. Furthermore, FIG. 21 shows a cleavage surface SEM image of the boundary in Example A2. The boundary is very sharp, indicating excellent pattern transfer accuracy during dry etching of the base structure.

Table 2

|  | Photoresist solution (viscosity, in cp) | Type | Side-etching width L ($\mu$m) |
|---|---|---|---|
| Reference Example A1 | - | - | 7.1 |
| Example A1 | OFPR800LB (34 cp)[*1] | Positive | 0.6 |
| Example A2 | MCPR2200X (20 cp)[*2] | Positive | 1.3 |
| Example A3 | Negative photoresist (90 cp)[*3] | Negative | 1.4 |
| Example A4 | AZ5200NJ (85 cp)[*4] | Positive/Negative | 1.7 |
| Example A5 | S1813[*5] | Positive | 1.7 |
| Example A6 | S1830[*6] | Positive | 2.2 |
| Example A7 | PFI-34A[*7] | Positive | 2.4 |
| Example A8 | AZ P4620[*8] | Positive | 2.2 |

*1) Tokyo Ohka Kogyo Co., Ltd.; novolac resin, naphthoquinonediazide, solvent: ethyl lactate;
*2) Rohm and Haas Company; novolac resin, naphthoquinonediazide, solvent: ethyl lactate, 1-methoxy-2-propyl acetate, 2-methoxy-1-propyl acetate;
*3) contains novolac resin, solvent: PGMEA, naphthoquinonediazide;
*4) AZ Electronic Materials K.K.; for both positive/negative; novolac resin derivative, naphthoquinonediazide, solvent :PGMEA(propylene glycol monomethyl acetate);
*5) Rohm and Haas Company; novolac resin, naphthoquinonediazide, solvent: 1-methoxy-2-propyl acetate;
*6) Rohm and Haas Company; resin, photosensitive material, solvent: 1-methoxy-2-propyl acetate;
*7) Sumitomo Chemical Co., Ltd.; novolac resin, photosensitive material, solvent: 2-heptanone;
*8) AZ Electronic Materials K.K.; novolac resin derivative, naphthoquinonediazide derivative, solvent: 1-methoxy-2-propyl acetate.

<<Experiment A2>>

Reference Examples A2, A3 and Examples A9 to A12

Experiments were conducted as described in Experiment A1, except that substrate temperatures during $SrF_2$ layer deposition were changed to those indicated in Table 3, from 450 °C used in Experiment A1. As shown in Table 3, Reference Example A2 or A3 was not treated with a resist composition while Examples A9 to A12 were treated with a photoresist solution indicated in the table. The results are shown together in Table 3.

Table 3

|  | Deposition temperature | Photoresist solution (Viscosity, in cp) | Type | Side-etching width L ($\mu$m) |
|---|---|---|---|---|
| Reference Example A2 | 350 °C | - | - | 2.9 |

(continued)

|  | Deposition temperature | Photoresist solution (Viscosity, in cp) | Type | Side-etching width L ($\mu$m) |
|---|---|---|---|---|
| Example A9 | 350 °C | MCPR2200X(20 cp) | Positive | 0 |
| Example A10 | 350 °C | MCPR2200X(61 cp) | Positive | 0 |
| Example A11 | 350 °C | as in Example 3 | Negative | 0 |
| Reference Example A3 | 250 °C | - | - | 2.9 |
| Example A12 | 250 °C | MCPR2200X(20 cp) | Positive | 0 |

<<Experiment A3>>

Examples A13 to A16

The treatment with a resist composition was conducted using a positive photoresist composition (MCPR2200X, from Rohm and Haas Company) as used in Example A2. As shown in Table 4, the effects of the presence of the first heating, exposure, the second heating and development were evaluated.

Table 4

| Treatment with a resist composition | | | | | | |
|---|---|---|---|---|---|---|
|  | First heating 85 °C/15 min | Exposure | Second heating 125 °C/15 min | Development | Washing with an organic solvent | Side-etching width L ($\mu$m) |
| Example A2 | conducted |  | conducted |  | conducted | 1.3 |
| Example A13 | conducted | conducted | conducted | conducted | conducted | 1.8 |
| Example A14 | conducted |  | conducted | conducted | conducted | 1.8 |
| Example A15 | conducted |  |  |  | conducted | 1.6 |
| Example A16 |  |  | conducted |  | conducted | 1.6 |

<<Experiment B1>>

Example B1

As described for Reference Experiment 1, on an Si-doped GaN semiconductor layer grown on a sapphire substrate by MOCVD was deposited an $SrF_2$ layer to 400 nm by vacuum deposition using resistance heating at a base structure temperature of 450 °C. The base structure having the deposited $SrF_2$ layer was immersed in aqueous solution of L-(+)-tartaric acid of a concentration of 50 % by weight at room temperature for 3 min and then washed with water for 3 min. After drying at room temperature, a positive photoresist composition (MCPR2200X, from Rohm and Haas Company) was spin-coated on the $SrF_2$ layer, which was then pre-baked and exposed through a photomask having a predetermined pattern. After post-exposure baking, the product was developed and washed and post-baked to terminate patterning of the photoresist. Then, using the etchant as described for Reference Experiment 1, the $SrF_2$ layer was wet-etched at room temperature for 3 min.

After the wet etching, a side-etching width L was observed by an optical microscopy. As seen from an microscopy image of FIG. 19B, the $SrF_2$ layer 3 and the photoresist film 4 are positioned in alignment with each other at the boundary X1, and a side-etching width L was 0 $\mu$m. FIG. 21B shows a cleavage surface SEM image of the boundary. The boundary is very sharp, indicating excellent pattern transfer accuracy during dry etching of the base structure.

Reference Example B1

Reference Example B1 is the same experiment as Reference Example A1 and was conducted as described for Example B1 except that the treatment with a chemical agent in Example B1 was not conducted. As shown in a microscopy image of FIG. 20, the boundary X2 of the $SrF_2$ layer 3 was recessed from the boundary X1 of the photoresist film 4, and the side-etching width L was 7.1 $\mu$m. FIG. 22 shows a cleavage surface SEM image of the boundary. The boundary shape was inferior to that of Example B1 with respect to sharpness.

Examples B2 to B18

Treatment with a chemical agent was conducted as described in Table 5. The results of Example B1 and Reference Example B1 are shown together.

Table 5

| | Chemical agent (concentration etc.) | Type | washing after treatment | Side- etching width L ($\mu$m) |
|---|---|---|---|---|
| Reference Example B1 | - | - | - | 7.1 |
| Example B1 | L-(+)-Tartaric acid (50 % aqueous solution) | Organic acid | Washing with water | 0 |
| Example B2 | D-(-)-Tartaric acid (50 % aqueous solution) | Organic acid | Washing with water | 1.6 |
| Example B3 | DL-Tartaric acid (12.5 % aqueous solution) | Organic acid | Washing with water | 1.8 |
| Example B4 | Citric acid (50 % aqueous solution) | Organic acid | Washing with water | 1.3 |
| Example B5 | Ammonium tartrate (50 % aqueous solution) | Organic acid | Washing with water | 1.6 |
| Example B6 | Lactic acid (neat) | Organic acid | Washing with water | 3.3 |
| Example B7 | Acetic acid (neat) | Organic acid | Washing with water | 3.3 |
| Example B8 | TMAH (5 % aqueous solution) | Alkaline solution | Washing with water | 1.5 |
| Example B9 | NaOH (1mol/L aqueous solution) | Alkaline solution | Washing with water | 1.4 |
| Example B10 | KOH (10 mol/L aqueous solution) | Alkaline solution | Washing with water | 2.1 |
| Example B11 | Acetone-IPA | Organic solvent | Washing with water | 2.9 |
| Example B12 | Water | | - | 2.8 |
| Example B13 | Methanol | Organic solvent | - | 4.2 |
| Example B14 | IPA | Organic solvent | - | 4.1 |
| Example B15 | Remover 1 (main component: N-methyl-2-pyrrolidone) | Organic solvent | Washing with water | 4.7 |
| Example B16 | Remover 2 (main component: 2-aminoethanol | Organic solvent | Washing with water | 4.7 |
| Example B17 | Ethyl lactate (neat) | Organic solvent | Washing with water | 3.1 |

(continued)

| | Chemical agent (concentration etc.) | Type | washing after treatment | Side- etching width L ($\mu$m) |
|---|---|---|---|---|
| Example B18 | HMDS (neat) | Hydrophobizing agent | Acetone-IPA-water (sequential washing) | 2.4 |
| Example B19 | HMDS (neat) | Hydrophobizing agent | Acetone | 5.1 |
| Example B20 | TMSOH (neat) | Hydrophobizing agent | Acetone | 5.4 |
| Example B21 | TMSOMe (neat) | Hydrophobizing agent | Acetone | 5.9 |

In the table, the abbreviations have the following meanings; TMAH: tetramethylammonium hydroxide, IPA: isopropylalcohol, HMDS: hexamethyldisilazane, TMSOH: trimethylsilanol, and TMSOMe: trimethylmethoxysilane.

<<Experiment B2>>

Example B22

On an Si-doped GaN semiconductor layer grown on a sapphire substrate by MOCVD was deposited a $CaF_2$ layer to a thickness of 0.22 $\mu$m by vacuum deposition using resistance heating at a base structure temperature of 450 °C. The surface state of the $CaF_2$ layer was observed by scanning electron microscopy (SEM). The results are shown in FIG. 27. As seen from FIG. 27, inter-particulate voids are observed in the $CaF_2$ layer as a solid layer and its surface porosity was about 0.9 %. Then, the base structure having the deposited $CaF_2$ layer except the region observed by SEM was immersed in an aqueous solution of L-(+)-tartaric acid of concentration of 50 % by weight at room temperature for 3 min, and then washed with water. After drying at room temperature, the process until determination of a side-etching width was conducted as described in Experiment B1. A side-etching width L between the $CaF_2$ layer and the photoresist film was 0.8 $\mu$m. From this result, $CaF_2$ is also considered to provide etching with excellent pattern transfer accuracy.

<<Experiment B3>>

Reference Example B2 and Examples B23 to B24

These experiments were conducted as described in Experiment B1, except substrate temperatures during $SrF_2$ layer deposition were 350 °C. The chemical agent described in Table 6 was used for the treatment. Table 6 shows the results.
Table 6

| | Chemical agent (concentration etc.) | Type | washing after treatment | Side-etching width L ($\mu$m) |
|---|---|---|---|---|
| Reference Example B2 | - | - | - | 2.9 |
| Example B23 | L-(+)-Tartaric acid (50 % aqueous solution) | Organic acid | Washing with water | 0 |
| Example B24 | TMAH (5 % aqueous solution) | Alkaline solution | Washing with water | 1.6 |

<<Experiment B4>>

An $SrF_2$ dissolution test by treatment with a chemical agent was conducted. In this dissolution test, samples of $SrF_2$ layer deposited at 450 °C as described in Example B1 were immersed in the chemical agents used in Experiment B1 for 3 min. ICP-MS measurement was conducted and using a calibration curve obtained from Sr standard solutions having known concentration, Sr concentration was determined, from which $SrF_2$ dissolution amount was determined. The results are shown below. A dissolution amount in % by weight was calculated from the following equation.

$$SrF_2 \text{ dissolution amount } (\%) = (SrF_2 \text{ dissolution amount into a}$$
$$\text{chemical agent}) \times 100/(\text{weight of an } SrF_2 \text{ layer})$$

Table 7

| Chemical agent | Dissolution amount |
|---|---|
| Aqueous NaOH solution (1 mol/L aqueous solution) | 40 % |
| L-(+)-Tartaric acid (50 % aqueous solution) | 0.99 % |
| IPA | 0.007 % |

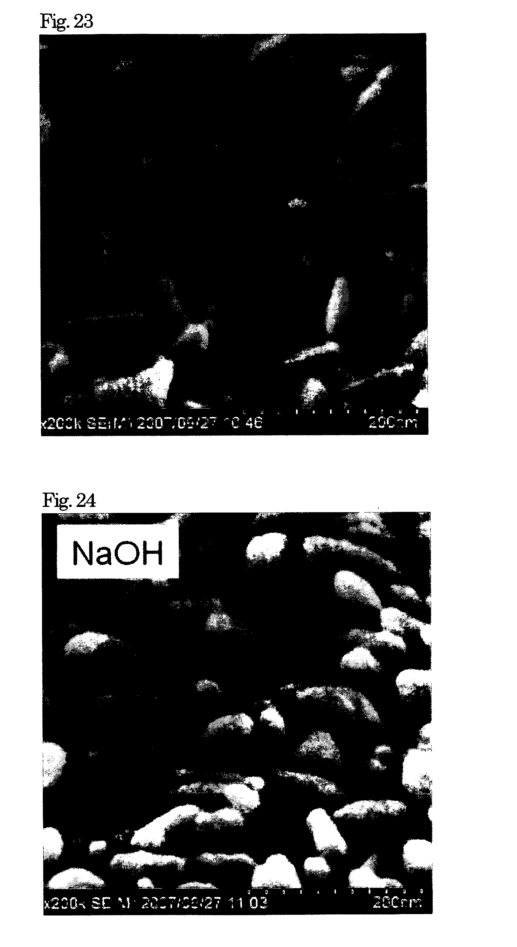

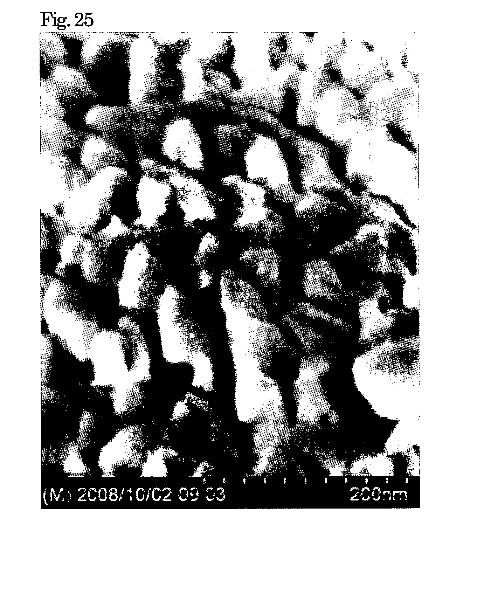

A SEM image of an $SrF_2$ layer without undergoing treatment with a chemical agent and SEM images of an $SrF_2$ layer after treatment with a chemical agent of Example B9 (NaOH treatment) and Example B10 (KOH treatment) are shown in FIGs. 23, 24 and 25, respectively. The results indicate that the edge of fine particles has been rounded after treatment with an aqueous NaOH or KOH solution. In treatment with tartaric acid, no distinguishable difference in the image was observed in comparison with the untreated $SrF_2$ layer.

<<Experiment C1>>

Example C1

As described for Reference Experiment 1, on an Si-doped GaN semiconductor layer grown on a sapphire substrate by MOCVD was deposited an $SrF_2$ layer to 400 nm by vacuum deposition using resistance heating at a base structure temperature of 450 °C. The base structure having the deposited $SrF_2$ layer was placed on a spin coater and a cresol novolac resin solution (Gunei Chemical Industry Co., Ltd., trade name: Resitop PSF-2808, a mixed solvent of 70 wt% of propylene glycol monomethyl ether and 30 wt% of propylene glycol monomethyl ether acetate, viscosity: 100 cps) was dropped on the deposited $SrF_2$ layer, which was then spin coated. Then, the product was heated at 85 °C for 15 min and then at 120 °C for 15 min. After cooling, washing with acetone, isopropanol and water were sequentially conducted for 3 min, respectively, to remove the polymer.

After drying at room temperature, for patterning the $SrF_2$ layer, a positive photoresist composition (MCPR2200X, from Rohm and Haas Company) was spin-coated on the $SrF_2$ layer, which was then pre-baked and exposed through a photomask having a predetermined pattern. After post-exposure baking, the product was developed and washed and post-baked to complete patterning of the photoresist. Then, using the etchant as described for Reference Experiment 1, the $SrF_2$ layer was wet-etched at room temperature for 3 min.

After the wet etching, a side-etching width L was observed by an optical microscopy. As shown in a microscopy image of FIG. 19C, the boundary X2 of the $SrF_2$ layer 3 was slightly recessed from the boundary X1 of the photoresist film 4, and the side-etching width L was 1.7 $\mu$m.

Reference Example C1

Reference Example C1 is the same experiment as Reference Example A1 and was conducted as described for Example C1 except that treatment with a polymer solution in Example C1 was not conducted. As shown in a microscopy image of FIG. 20, the boundary X2 of the $SrF_2$ layer 3 was recessed from the boundary X1 of the photoresist film 4, and the side-etching width L was 7.1 $\mu$m.

Example C2

Treatment with a polymer solution was conducted as described in Table 8. The results of Example C1 and Reference Example C1 are shown together.

Table 8

| | Polymer solution | Side-etching width L ($\mu$m) |
|---|---|---|
| Reference Example C1 | - | 7.1 |
| Example C1 | Cresol novolac resin (viscosity, 100 cps) | 1.7 |
| Example C2 | Cresol novolac resin (viscosity, 20 cps)[*1] | 2.4 |
| *1) The solvent is as in Example C1. | | |

<<Experiment C2>>

Reference Example C2 and Example C3

These experiments were conducted as described in Experiment C1, except substrate temperatures during SrF$_2$ layer deposition were 350 °C. The polymer solution described in Table 9 was used for the treatment. Reference Example C2 is an example without treatment with a polymer solution. Table 9 shows the results.

Table 9

| | Polymer solution | Side-etching width L ($\mu$m) |
|---|---|---|
| Reference Example C2 | - | 2.9 |
| Example C3 | Cresol novolac resin (the solution used in Example C2) | 1.2 |

Device Formation Example 1

With reference to FIGs. 1 to 8, there will be described an example where an inter-element separation trench is formed in a semiconductor layer constituting a semiconductor light-emitting device by etching. The present invention is applied to the Device Formation Example by, after SrF2 layer is formed, treating the SrF$_2$ layer with a liquid {(A) treatment with a resist composition, (B) treatment with a chemical agent and (C) treatment with a polymer solution}, and washing if necessary.

First, was prepared a c+ plane sapphire substrate 1 with a thickness of 430 $\mu$m, on which was formed a semiconductor layer 2 as described below. By MOCVD were formed an undoped GaN layer with a thickness of 10 nm grown at a low temperature as a first buffer layer and then an undoped GaN layer with a thickness of 1 $\mu$m at 1040 °C as a second buffer layer. Then, an Si-doped (Si concentration: $5\times10^{18}$ cm$^{-3}$) GaN layer was formed to a thickness of 4 $\mu$m as a first conductivity type (n-type) second cladding layer, an Si-doped (Si concentration: $1\times10^{19}$ cm$^{-3}$) GaN layer was formed to a thickness of 0.5 $\mu$m as a first conductivity type (n-type) contact layer, and an Si-doped (Si concentration: $5.0\times10^{18}$ cm$^{-3}$) Al$_{0.15}$Ga$_{0.85}$N layer was formed to a thickness of 0.1 $\mu$m as a first conductivity type (n-type) first cladding layer. Furthermore, an active layer structure was formed by depositing alternately undoped GaN layer to a thickness of 13 nm at 850 °C as a barrier layer and undoped In$_{0.1}$Ga$_{0.9}$N layer to a thickness of 2 nm at 720 °C as a quantum well layer, such that five quantum well layers in total were formed and both sides were barrier layers. Subsequently, at a growth temperature of 1025 °C was formed an Mg-doped (Mg concentration: $1\times10^{19}$ cm$^{-3}$) Al$_{0.15}$Ga$_{0.85}$N layer to a thickness of 0.1 $\mu$m as a second conductivity type (p-type) first cladding layer. Continuously, was formed an Mg-doped (Mg concentration: $1\times10^{19}$ cm$^{-3}$) GaN layer to a thickness of 0.05 $\mu$m as a second conductivity type (p-type) second cladding layer. Finally, was formed an Mg-doped (Mg concentration: $1\times10^{19}$ cm$^{-3}$) GaN layer to a thickness of 0.02 $\mu$m as a second conductivity type (p-type) contact layer.

Then, after gradually lowering the temperature of the MOCVD growth reactor, the wafer was taken out and thus thin film crystal growth was completed to prepare the structure shown in FIG. 1 after forming the semiconductor layer.

Then, as shown in FIG. 2, was formed an SrF$_2$ single layer as an etching mask layer 3 to a thickness of 400 nm by vacuum evaporation at 450 °C at a vapor deposition rate of 0.2 nm/sec. Next, as shown in FIG. 3, a resist mask layer 4 was formed by spin coating and then a resist pattern was formed by photolithography. Then, for patterning the etching mask layer 3 (SrF$_2$ monolayer) using a resist pattern 4, the wafer was immersed in an etchant of 1:10 (by volume) hydrochloric acid (hydrogen chloride content: 36 %) and water for 240 sec to etch the SrF$_2$ layer as shown in FIG. 5A. The etched SrF$_2$ layer had good linearity as reflecting the photo mask pattern, was free from unintended detachment and maintained high adherence. Then, the resist layer was removed as shown in FIG. 6 by acetone and oxygen plasma ashing to expose the SrF$_2$ layer as an etching mask. Then, the whole semiconductor epitaxial layer in a part corresponding to an inter-element separation trench was etched using inductively-coupled chlorine plasma as shown in FIG. 7. During the dry etching, despite the fact that the thick (average: 5.868 μm) GaN-based material with a thickness of more than 5.8 μm was dry-etched, the SrF$_2$ layer was little etched. Finally, as shown in FIG. 8, the wafer was immersed in an etchant of 1: 10 (by volume) hydrochloric acid/water for 300 sec for completely removing the unneeded SrF$_2$ layer, to complete formation of a trench for inter-element separation in a semiconductor light-emitting device. The inter-element separation trench prepared had a width of 100 μm.

Device Formation Example 2

Another example will be described with reference to FIGs. 1 and 9 to 12. The present invention is applied to this-Example, similarly by, after SrF2 layer is formed, treating the SrF$_2$ layer with a liquid {(A) treatment with a resist composition, (B) treatment with a chemical agent and (C) treatment with a polymer solution}, and washing if necessary.

First, was prepared a c+ plane sapphire substrate 1 with a thickness of 430 μm, on which was formed a semiconductor layer 2 as described below. By MOCVD were formed an undoped GaN layer with a thickness of 20 nm grown at a low temperature as a first buffer layer and then an undoped GaN layer with a thickness of 1 μm at 1040 °C as a second buffer layer 2. Continuously, an Si-doped (Si concentration: 5×10$^{18}$ cm$^{-3}$) GaN layer was formed to a thickness of 5 μm as a first conductivity type (n-type) second cladding layer, an Si-doped (Si concentration: 1×10$^{19}$ cm$^{-3}$) GaN layer was formed to a thickness of 0.5 μm as a first conductivity type (n-type) contact layer, and an Si-doped (Si concentration: 1×10$^{19}$ cm$^{-3}$) Al$_{0.15}$Ga$_{0.85}$N layer was formed to a thickness of 0.1 μm as a first conductivity type (n-type) first cladding layer. Furthermore, an active layer structure was formed by depositing alternately undoped GaN layer to a thickness of 13 nm at 850 °C as a barrier layer and undoped In$_{0.06}$Ga$_{0.94}$N layer to a thickness of 3 nm at 715 °C as a quantum well layer, such that six quantum well layers in total were formed and both sides were barrier layers. Subsequently, at a growth temperature of 1025 °C was formed an Mg-doped (Mg concentration: 1×10$^{19}$ cm$^{-3}$) Al$_{0.15}$Ga$_{0.85}$N layer to a thickness of 0.1 μm as a second conductivity type (p-type) first cladding layer. Continuously, was formed an Mg-doped (Mg concentration: 1×10$^{19}$ cm$^{-3}$) GaN layer to a thickness of 0.05 μm as a second conductivity type (p-type) second cladding layer. Finally, was formed an Mg-doped (Mg concentration: 1×10$^{19}$ cm$^{-3}$) GaN layer to a thickness of 0.02 μm as a second conductivity type (p-type) contact layer.

Then, after gradually lowering the temperature of the MOCVD growth reactor, the wafer was taken out and thus thin film crystal growth was completed (the structure in FIG. 1).

An etching mask was formed for conducting the first etching step of exposing the first conductivity type (n-type) contact layer in the semiconductor stacked structure after completion of the epitaxial growth. Here, over the whole surface of the semiconductor layer was formed an SrF$_2$ layer by vacuum evaporation at a substrate temperature of 200 °C and a vapor deposition rate of 0.5 nm/sec. Then, a photoresist pattern was formed on the SrF$_2$ layer by photolithography and the SrF$_2$ layer was partially etched for patterning by hydrochloric acid to prepare a first etching mask. Next, as a first etching step, inductively-coupled plasma using BCl$_3$ gas was used to etch the active layer structure consisting of the p-GaN contact layer, the p-GaN second cladding layer, the p-AlGaN first cladding layer, the active layer of the InGaN quantum well layer and the GaN barrier layer, the n-AlGaN first cladding layer and the intermediate portion of the n-GaN contact layer, to expose an n-type contact layer to be an injection part for n-type carrier.

After completion of plasma etching by inductively-coupled plasma, the whole SrF$_2$ mask layer was removed by hydrochloric acid. Here, the SrF$_2$ mask deposited at a substrate temperature of 200 °C was a mask exhibiting good linearity during patterning as reflecting the photo mask pattern, which was little etched by plasma etching and exhibited good resistance to chlorine-containing plasma etching.

Next, over the thus-formed step was formed, by photolithography, a resist pattern for patterning a p-side electrode 7 by a lift-off method. As a metal layer A for forming a p-side electrode 7, Pd and Au were deposited to 20 nm and 1000 nm, respectively, by vacuum evaporation, and then an unneeded part was removed in acetone by a lift-off method. Then, a p-side electrode was formed after heat treatment (formation of the p-side electrode 7 in FIG. 9). Thus, since the p-side electrode 7 was formed without using, for example, a plasma process, a p-side current injection region was not damaged.

Then, a further resist pattern was formed, by photolithography, for patterning an n-side electrode 8 by a lift-off method. Here, over the whole surface of the wafer was formed Ti (thickness: 20 nm)/Al (thickness: 1500 nm) as a metal layer for forming an n-side electrode by vacuum evaporation, and the unneeded part was removed in acetone by a lift-off method. Then, an n-side electrode 8 was formed by heating (formation of the n-side electrode 8 in FIG. 9).

After the above process, the structure in FIG. 9 was formed.

Subsequently, for forming an etching mask layer 9 as a multilayer film of an SiN$_x$ and an SrF$_2$ films, the SiN$_x$ film was first formed to a thickness of 200 nm by p-CVD at a deposition temperature of 400 °C. Then, at an elevated temperature of 400 °C, the SrF$_2$ layer mask was formed to a thickness of 400 nm. Here, the SrF$_2$ mask was formed by vapor deposition at a rate of 0.5 nm/sec while a dome equipped with a sample was rotated and revolved, to provide the configuration in FIG. 10.

Then, for separation between light-emitting units, photolithography was used to form a photoresist pattern having an opening in an area for forming a separation trench, and the resist mask was used for wet etching of the etching mask layer 9 having a stacked structure of $SrF_2$ and $SiN_x$ to form an opening 10. The $SrF_2$ layer was selectively etched for 240 sec using an etchant of hydrochloric acid (hydrogen chloride content: 36 %):water=1:10 by volume, and then the $SiN_x$ layer was selectively etched for 3 min using an etchant of 1:5 (by volume) hydrofluoric acid : ammonium fluoride. Thus, there was provided a patterned etching mask layer in which both $SrF_2$ and $SiN_x$ parts exhibited good linearity as reflecting the photo mask pattern and good adhesiveness (FIG. 11).

Then, in the structure of FIG. 11, the semiconductor layer 2 was dry-etched by inductively-coupled plasma excitation using $Cl_2$ gas from the opening in the etching mask layer 9, to form a separation trench 11. During the etching, the multilayer mask used as an etching mask was little etched (FIG. 12).

Finally, the wafer was immersed in hydrochloric acid for 5 min to completely remove the $SrF_2$ part. Here, the $SiN_x$ mask part was not etched at all. Therefore, the electrode layer was not damaged by hydrochloric acid. Then, for removing the unneeded $SiN_x$ mask, the $SiN_x$ mask was removed by reactive etching using $SF_6$ gas for 1 min, to provide the configuration in FIG. 13.

Then, elements were cut out along the trench formed for inter-element separation to provide a light-emitting device.

Industrial Applicability

According to the etching method of the present invention, an etching-resistant semiconductor layer, such as a Group III-V nitride semiconductor layer, can be etched easily and precisely.

**Claims**

1. An etching method, comprising the steps of:

   forming a solid layer made of a metal fluoride at least as a part of an etching mask on the surface of a base structure;
   treating the solid layer with a liquid; and
   etching the base structure using the liquid-treated solid layer as a mask.

2. The etching method as claimed in Claim 1, wherein the liquid is a resist composition.

3. The etching method as claimed in Claim 2, wherein the step of treating with a resist composition comprises, as obligatory substeps,
   substep (1): applying a resist composition to the solid layer; and substep (6): removing the resist composition.

4. The etching method as claimed in Claim 3, wherein the step of treating with a resist composition further comprises at least one step selected from the substep group consisting of:

   substep (2): first heating,
   substep (3): first exposure,
   substep (4): second heating and
   substep (5): second exposure; and
   wherein these substeps, together with the substeps (1) and (6), are performed in ascending order.

5. The etching method as claimed in Claim 1, wherein the liquid is a chemical agent.

6. The etching method as claimed in Claim 5, wherein the chemical agent contains at least one selected from the group consisting of water, an organic solvent, an organic acid, an alkaline solution and a hydrophobizing agent.

7. The etching method as claimed in Claim 1, wherein the liquid is a polymer solution.

8. The etching method as claimed in Claim 7, wherein the step of treating with a polymer solution comprises:

substep: applying a polymer solution to the solid layer, and
substep: removing the polymer on the solid layer.

9. The etching method as claimed in Claim 8, wherein the step of removing the polymer comprises washing with a solvent.

10. The etching method as claimed in any of Claims 1 to 9, comprising, after the step of treating with a liquid, steps of:

   forming a patterned resist mask on the solid layer; and
   etching the solid layer using the resist mask as an etching mask.

11. The etching method as claimed in Claim 10, wherein the resist mask is formed from a photoresist.

12. The etching method as claimed in Claim 10 or 11, wherein the step of etching a solid layer is conducted by wet etching.

13. The etching method as claimed in Claim 12, wherein an etchant used in the wet etching contains at least one selected from the group consisting of hydrochloric acid, hydrofluoric acid and concentrated sulfuric acid.

14. The etching method as claimed in any one of Claims 1 to 13, wherein the solid layer is formed at a temperature of 150 °C to 480 °C.

15. The etching method as claimed in any one of Claims 1 to 14, wherein the solid layer is selected from the group consisting of $SrF_2$, $AlF_3$, $MgF_2$, $BaF_2$, $CaF_2$ and combinations thereof.

16. The etching method as claimed in any one of Claims 1 to 15, wherein the step of etching a base structure is conducted by dry etching.

17. The etching method as claimed in Claim 16, wherein the dry etching is plasma-excited dry etching using a gas species containing at least chlorine atom.

18. The etching method as claimed in any one of Claims 1 to 17, comprising step of removing the solid layer by an etchant containing an acid or alkali after the step of etching a base structure.

19. The etching method as claimed in any one of Claims 1 to 18, wherein the etching mask formed on the base structure comprises a multilayer structure having the solid layer and a second mask layer made of a material other than the material for the solid layer.

20. The etching method as claimed in any one of Claims 1 to 19, wherein the base structure comprises a Group III-V nitride layer.

21. The etching method as claimed in Claim 10, wherein a side-etching width measured from the patterned resist mask edge, which generates during step of etching the solid layer, is 6 $\mu$m or less.

22. The etching method as claimed in Claim 21, wherein a side-etching width measured from the patterned resist mask edge, which generates during etching the solid layer, is 2 $\mu$m or less.

23. An etching method, comprising the steps of:

   forming a solid layer having an inter-particulate void at least as a part of an etching mask on the surface of a base structure;
   treating the solid layer with a liquid; and
   etching the base structure using the liquid-treated solid layer as a mask.

24. A process for manufacturing a photo/electronic device comprising the etching method as claimed in any of Claims 1 to 23, as one step.

Fig. 1

| |
|---|
| 2  Semiconductor layer |
| 1  Substrate |

Fig. 2

| |
|---|
| 3  Etching mask layer |
| 2  Semiconductor layer |
| 1  Substrate |

Fig. 3

| 4 Resist mask layer |
| 3 Etching mask layer |
| 2 Semiconductor layer |
| 1 Substrate |

Fig. 4

4 Resist mask layer

3 Etching mask layer

2 Semiconductor layer

1 Substrate

Fig. 5A

4 Resist mask layer

3 Etching mask layer

2 Semiconductor layer

1 Substrate

Fig. 5B

4

3

2

L

Fig. 6

3 Etching mask layer

2 Semiconductor layer

1 Substrate

Fig. 7

3 Etching mask layer

2 Semiconductor layer

1 Substrate

Fig. 8

2 Semiconductor layer

1 Substrate

Fig. 9

7

8

2

1

Fig. 10

Fig. 11

Fig. 12

Fig. 13

Fig. 14

Fig. 15

Fig. 16A

Fig. 16B

Fig. 17

Fig. 18

Fig. 19

Fig. 19B

Fig. 19C

Fig. 20

Fig. 21

Fig. 21B

Fig. 22

Fig. 23

Fig. 24

Fig. 25

(M.) 2008/10/02 09:03                    200nm

Fig. 26

Fig. 27

## INTERNATIONAL SEARCH REPORT

International application No.

PCT/JP2008/069920

### A. CLASSIFICATION OF SUBJECT MATTER
*H01L21/3065*(2006.01)i, *H01L21/306*(2006.01)i, *H01L33/00*(2006.01)i

According to International Patent Classification (IPC) or to both national classification and IPC

### B. FIELDS SEARCHED

Minimum documentation searched (classification system followed by classification symbols)
H01L21/3065, H01L21/306, H01L33/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2006/082322 A1 (CENTRE NATIONAL DE LA RECHERCHE SCIENTIFIQUE-CNRS-), 10 August, 2006 (10.08.06), Full text; all drawings & EP 1856778 A & FR 2881876 A | 1-9,14-24 |
| X | JP 5-267793 A (NEC Corp.), 15 October, 1993 (15.10.93), Full text; all drawings (Family: none) | 1-9,14-24 |
| X | JP 2-28334 A (Menlo Industries, Inc.), 30 January, 1990 (30.01.90), Full text; all drawings & US 5034347 A | 1-9,14-24 |

☒ Further documents are listed in the continuation of Box C.  ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>25 November, 2008 (25.11.08) | Date of mailing of the international search report<br>02 December, 2008 (02.12.08) |
|---|---|
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2008/069920

C (Continuation).   DOCUMENTS CONSIDERED TO BE RELEVANT

| Category* | Citation of document, with indication, where appropriate, of the relevant passages | Relevant to claim No. |
|---|---|---|
| X | JP 63-140537 A  (Oki Electric Industry Co., Ltd.), 13 June, 1988 (13.06.88), Full text; all drawings (Family: none) | 1-9,14-24 |
| X | JP 6-310471 A  (NEC Corp.), 04 November, 1994 (04.11.94), Full text; all drawings (Family: none) | 1-9,14-24 |
| X | JP 5-36648 A  (Toshiba Corp.), 12 February, 1993 (12.02.93), Full text; all drawings (Family: none) | 1-9,14-24 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11150303 A
- JP 2002026384 A
- JP 6310471 A
- JP 5036648 A

**Non-patent literature cited in the description**

- *Journal of Vacuum Science and Technology B,* 1990, vol. 8, 28
- *Journal of Vacuum Science and Technology,* 1990, vol. 8, 28